(19) Europäisches Patentamt
European Patent Office
Office européen des brevets

(11) **EP 1 790 101 B1**

(12) **EUROPÄISCHE PATENTSCHRIFT**

(45) Veröffentlichungstag und Bekanntmachung des Hinweises auf die Patenterteilung:
**07.01.2015 Patentblatt 2015/02**

(51) Int Cl.:
***H03M 13/37*** *(2006.01)*    ***H03M 13/27*** *(2006.01)*
***H04L 1/00*** *(2006.01)*    *H03M 13/09* *(2006.01)*
*H03M 13/15* *(2006.01)*

(21) Anmeldenummer: **05757020.2**

(22) Anmeldetag: **19.07.2005**

(86) Internationale Anmeldenummer:
**PCT/EP2005/007310**

(87) Internationale Veröffentlichungsnummer:
**WO 2006/029665 (23.03.2006 Gazette 2006/12)**

(54) **SENDER UND EMPFÄNGER FÜR DIE ÜBERTRAGUNG VON DIGITALEN INFORMATIONSPAKETEN UNTER VERWENDUNG VON VORWÄRTSFEHLERKORREKTUR**

TRANSMITTER AND RECEIVER FOR TRANSMITTING DIGITAL INFORMATION PACKETS USING FORWARD ERROR CORRECTION

EMETTEUR ET RECEPTEUR POUR TRANSMETTRE DES PAQUETS D'INFORMATIONS NUMERIQUES PAR UTILISATION DE LA CORRECTION D'ERREUR AVANT

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **16.09.2004 DE 102004045000**

(43) Veröffentlichungstag der Anmeldung:
**30.05.2007 Patentblatt 2007/22**

(73) Patentinhaber: **Fraunhofer-Gesellschaft zur Förderung der angewandten Forschung e.V.
80686 München (DE)**

(72) Erfinder:
• **PROSCH, Markus**
  **91058 Erlangen (DE)**
• **ZINK, Alexander**
  **96135 Stegaurach (DE)**
• **LINZ, Bernd**
  **91052 Erlangen (DE)**

(74) Vertreter: **Schenk, Markus et al
Schoppe, Zimmermann, Stöckeler & Zinkler
Patentanwälte
Postfach 246
82043 Pullach bei München (DE)**

(56) Entgegenhaltungen:
EP-A- 1 014 730    WO-A-03/107581
WO-A-2005/050901   US-A1- 2003 207 696

• LIEBL LNT G ET AL: "An RTP Payload Format for Erasure-Resilient Transmission of Progressive Multimedia Streams" IETF STANDARD-WORKING-DRAFT, INTERNET ENGINEERING TASK FORCE, IETF, CH, Bd. avt, Nr. 6, Oktober 2003 (2003-10), XP015015997 ISSN: 0000-0004
• BOYCE J M: "Packet loss resilient transmission of MPEG video over the Internet - Principles, Protocols, and Architecture" SIGNAL PROCESSING. IMAGE COMMUNICATION, ELSEVIER SCIENCE PUBLISHERS, AMSTERDAM, NL, Bd. 15, Nr. 1-2, September 1999 (1999-09), Seiten 7-24, XP004180635 ISSN: 0923-5965
• HORN U ET AL: "Robust Internet video transmission based on scalable coding and unequal error protection" SIGNAL PROCESSING. IMAGE COMMUNICATION, ELSEVIER SCIENCE PUBLISHERS, AMSTERDAM, NL, Bd. 15, Nr. 1-2, September 1999 (1999-09), Seiten 77-94, XP004180639 ISSN: 0923-5965
• ROSENBERG J ET AL: "An RTP Payload Format for Generic Forward Error Correction" IETF STANDARD, INTERNET ENGINEERING TASK FORCE, IETF, CH, Nr. RFC2733, Dezember 1999 (1999-12), XP015008516 ISSN: 0000-0003

**Beschreibung**

Die vorliegende Erfindung betrifft das technische Gebiet der digitalen Nachrichtenübertragung und insbesondere betrifft die vorliegende Erfindung das technische Gebiet der digitalen Rundfunktechnik.

Fehlerschutzmechanismen werden seit längerem eingesetzt, um Fehler bei der Datenübertragung zu erkennen und zu beheben. Durch den Einsatz digitaler Rundfunksysteme konnten viele Fehlerquellen der analogen Systeme ausgeschlossen werden. Übertragungsfehler können dennoch nicht vermieden werden. Funkübertragungssysteme sind allgemein anfälliger für Störungen als kabelgebundene Systeme, da die Umwelteinflüsse während der Übertragungsstrecke zum Tragen kommen und die Signalqualität mehr beeinflussen und wegen Unidirektionalität dieser Systeme ein Nachfordern von Daten nicht möglich ist. Übertragungsfehler können einen Verlust von Teilen der Nachricht und so einen Empfangsausfall bewirken. Auch kann bei singulären Störungen ein Empfang der Nachricht in fehlerbehafteter und damit verfälschter Form vorkommen.

Fehlerschutzkodierung wird eingesetzt, um die Auswirkungen von Empfangsfehlern, die durch Störungen während der Übertragung entstehen, zu minimieren und somit die Daten zu schützen. Dabei gibt es zwei verschiedene Fehlerschutzmechanismen. Während bei der Fehlererkennung nur Fehler erkannt werden können, ist es mit der Fehlerkorrektur bzw. einer Vorwärtsfehlerkorrektur (FEC = Forward Error Correction = Vorwärtsfehlerkorrektur) möglich, Empfangsfehler ohne zusätzliche Neuaussendung der Daten zu beheben.

Nachteilig bei beiden Mechanismen ist, dass sie immer zusätzliche Bandbreite erfordern, um die redundanten Informationen für Fehlerdetektion bzw. Fehlerkorrektur zu übertragen. Für einen Kanal fester Bandbreite reduziert sich entsprechend die verfügbare Nutzdatenrate.

Weiterhin zeigte sich, dass sich neben den häufig vorkommenden Einzelfehlern auch Burstfehler besonders gravierend bei digitalen Übertragungssystemen auswirken.

Die Wahrscheinlichkeit von Burstfehlern steigt noch bei Betrachtung eines realen mobilen Empfangs. Bei schlechtem Empfang, durch Abschattung des Signals durch Gebäude, Berge oder Vegetation bzw. bei Fahrt durch einen Tunnel, können hintereinander mehrere digitale Datengruppen (Blöcke von mehreren Bytes) verloren gehen.

Durch die bei dem digitalen Rundfunkstandard DAB (DAB = Digital Audio Broadcasting) in Standardisierung befindlichen Fehlerkorrekturalgorithmen der unteren Transportschichten (beispielsweise der OSI-Schicht DataLink) können Einzelbitfehler innerhalb einer digitalen Datengruppe bzw. einer MSC-Datengruppe (MSC = Main Service Channel) eventuell behoben werden, wohingegen länger andauernde Empfangsfehler in zeitlich aufeinander folgenden MSC-Datengruppen (entstanden z.B. durch die Abschattung) mit ihnen nicht korrigiert werden können. Daher sollten bei der Bereitstellung eines Fehlerschutzes für das DAB-verwendete MOT-Protokoll (MOT = Multimedia Object Transfer) besonders die Burstfehler beachtet werden.

Da bei FEC-Algorithmen pro Codewort immer nur eine bestimmte Anzahl von Symbolfehlern korrigiert werden können, kann es bei Auftreten mehrerer Übertragungsfehler hintereinander vorkommen, dass zu viele Symbole innerhalb eines Codewortes gestört werden und eine Rekonstruktion des gesamten Codewortes unmöglich ist. Ein solches Problem kann beispielsweise durch die Verwendung eines Interleavers behoben werden, wie es beispielsweise in der Veröffentlichung "Realization of Optimum Interleavers" von John L. Ramsey (IEEE Transactions on Information Theory, vol. IT-16, No. 3, May 1970) näher beschrieben ist.

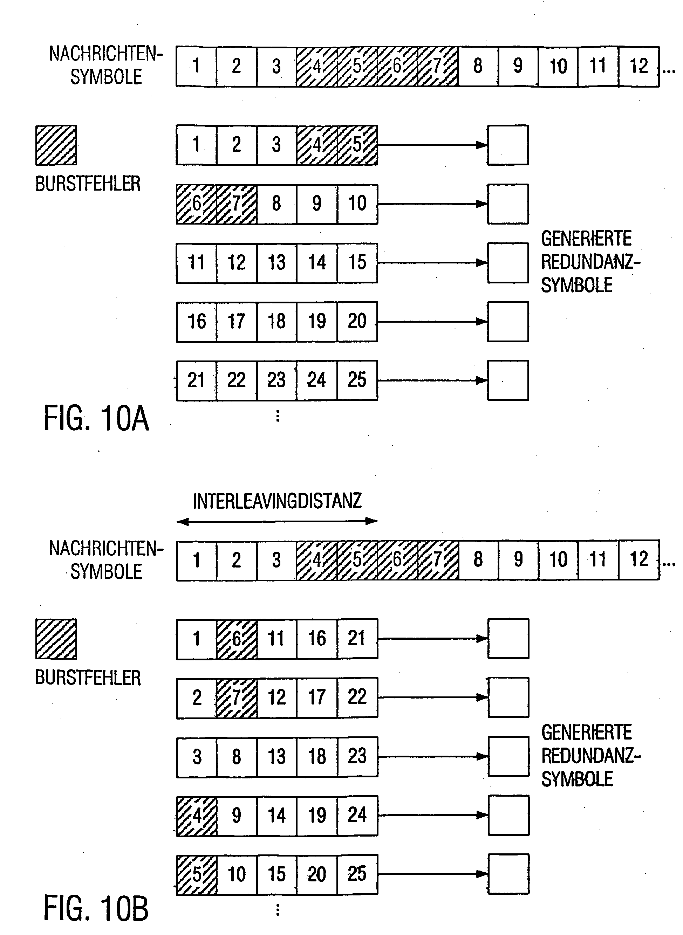

Unter Verwendung eines Interleavers werden dann die Symbole zur Bildung eines Codewortes nicht aufeinander folgend aus dem Datenstrom entnommen, sondern Symbole im Abstand der jeweiligen Interleaving-Distanz werden zu einem Codewort zusammengefasst. Aus diesem Nachrichtencodewort können dann in einem weiteren Schritt die für eine Fehlerschutzcodierung nötige Redundanzsymbole gebildet werden. Mit dieser Technik werden die Auswirkungen eines Burstfehlers, also der Störung mehrerer aufeinander folgender Symbole, minimiert. In Fig. 10A und 10B ist die Wirkungsweise eines solchen Interleavers anhand der Bildung eines Redundanzsymbols aus einem Nachrichtenwort von fünf Symbolen Länge bei einer Rekonstruktionsfähigkeit von einem verlorenen Symbol pro Codewort näher dargestellt. Der in Fig. 10A dargestellte Fall entspricht der Bildung der Redundanzsymbole aus aufeinander folgenden Codesymbolen ohne Interleaving. Der gestreifte Bereich stellt dabei einen Burstfehler dar, der jeweils zwei Codesymbole aufeinander folgender Codeworte zerstört. Bei der hier angenommenen Rekonstruktionsfähigkeit können die beiden zerstörten Codeworte, trotz Fehlerkorrekturmechanismus, empfangsseitig nicht wieder hergestellt werden, da in beiden jeweils zwei Symbole zerstört wurden, aber nur eines korrigiert werden könnte.

Dagegen verdeutlicht der in Fig. 10B dargestellte Fall das Auftreten desselben Burstfehlers, hier jedoch unter Verwendung der Technik des Interleavings bei der Codewortbildung. Die einzelnen Symbole eines Codewortes entsprechen nicht mehr aufeinanderfolgenden Symbolen im Datenstrom. Durch virtuelle Umsortierung der Symbole werden Symbole mit dem Abstand der Interleavingdistanz zur Bildung eines Codewortes und damit zur Generierung eines Redundanzsymbols gewählt. Der auftretende Burstfehler zerstört in diesem Beispiel jeweils nur noch maximal ein Codesymbol in vier verschiedenen Codewörtern. Diese können mit Hilfe des Redundanzsymbols und des verwendeten Fehlerschutzalgorithmus empfangsseitig wieder hergestellt werden.

Nachteilig weist sich die Vorwärtsfehlererkorrektur (FEC) dadurch aus, dass immer zusätzliche Bandbreite erforderlich ist, um die Redundanteninformationen für Fehlerdetektion bzw. Fehlerkorrektur übertragen zu können. Für einen Kanal fester Bandbreite reduziert sich deshalb entsprechend die verfügbare Nutzdatenrate. In Bezug auf den Interleaver ist anzumerken, dass durch die Umsortierung der Daten immer auch eine gewisse Latenz der Übertragung im Empfänger zu berücksichtigen ist, was beispielsweise für Streaming-Anwendungen wie Video zu einer von Nutzern nicht akzeptierten hohen Verzögerung führen kann.

Wie oben bereits erwähnt, schützen Vorwärtsfehlerkorrekturdaten (FEC-Daten) typischerweise eine feste Anzahl von Bytes. Dies wird gemacht, um die Nutzdaten sehr einfach von den FEC-Daten unterscheiden zu können. Es wird die bekannte feste Anzahl von Nutzdaten ausgesendet, danach sollten dann die FEC-Daten kommen, danach wieder Nutzdaten und so weiter. Es ist wichtig darauf hinzuweisen, dass die Vorwärtsfehlerkorrektur eingesetzt wird, wenn mit einer Störung der Daten gerechnet werden muss. Dieser einfache FEC-Ansatz erlaubt auch für den Fall, dass viele Daten gestört sind, noch zwischen Nutzdaten und FEC-Daten unterscheiden zu können.

Werden nun Daten unter Verwendung von mehreren Protokollschichten übertragen, werden die Daten auf den höheren Protokollschichten zu Datengruppen zusammengefasst und diese Datengruppen auf niedrigeren Protokollschichten bit- oder byteweise übertragen. Auf der Datengruppenebene (d.h. beispielsweise in den höheren OSI-Protokollschichten; OSI = Open System Interconnection) treten meist keine gestörten Daten auf. Wenn ein Übertragungsfehler ein Byte in einer niedrigeren Protokollschicht gestört hat (und der Fehlerschutz auf dieser Protokollebene unterhalb der Datengruppen dies nicht korrigieren kann), so wird dies dazu führen, dass die komplette Datengruppe beispielsweise aufgrund eines CRC-Fehlers, verworfen wird, die dieses gestörte Byte enthielt. Auf der Datengruppenebene treten also keine gestörten Datengruppen auf, aber komplette (relativ lange) Datenblöcke können fehlen.

Auf der Datengruppenebene ist es somit notwendig, den Verlust von einer oder mehreren Datengruppen zu erkennen und zu korrigieren. Problematisch ist dabei, dass die Länge von Datengruppen bei den unterschiedlichen Übertragungsprotokollen variabel sein kann, d.h. es ist nicht mehr so einfach, die FEC-Daten nach einer festen Anzahl von Bytes zu generieren bzw. empfangsseitig anzuwenden. Ebenfalls sollte empfangsseitig nicht nur der Verlust einer Folge von Datengruppen erkannt werden können, sondern genau ermittelbar sein, welche Datengruppen in welcher Länge bei einer Übertragung verloren gegangen sind. Möglichst viele dieser verlorenen Datengruppen sollten dann rekonstruiert werden können.

Ferner ist anzumerken, dass die Datenrate auf der Datengruppenebene variabel ist und sich typischerweise mehrere Datendienstanwendungen einen Übertragungskanal teilen. Dies bedeutet mit anderen Worten, dass ein Ansatz, bei dem eine feste Anzahl von Daten aus dem Kanal als Nutzdaten bzw. als FEC-Daten entnommen werden, hier nicht anwendbar ist. Der Vorwärtsfehlerkorrekturalgorithmus "sieht" empfangsseitig nicht alle Daten, sondern nur die, die zweifelsfrei (weil beispielsweise mit korrekter Prüfsumme in untergeordnete Übertragungsprotokollschichten) für einen bestimmten Datendienst empfangen wurden.

Die US 2003/0207696 A1 beschreibt Techniken zur Implementierung von Multimedia-Broadcast- und Multicast-Services (MBMS) in einem Drahtloskommunikationssystem. Für den Fall einer hohen Anzahl an Endgeräten wird dort die Einführung eines äußeren Codes zur Fehlerkorrektur vorgeschlagen. Dafür werden die Frames von MBMS-Daten zeilenweise in eine Matrix eingeschrieben, um an dieser Matrix spaltenweise CRC-Codes zu erzeugen und die MBMS-Frames dann zusammen mit entsprechenden Paritäts-Frames auszusenden. Es werden Ausführungsbeispiele vorgestellt, wonach von Sende- an Empfangsseite explizite Informationen darüber mitgesendet werden, wie die Codeblock-Struktur aussieht, damit verlorengegangene Frames auf Empfangsseite nicht dazu führen, dass die Blockstruktur außer Synchronisation mit der Sendeseite gerät. Zur expliziten Signalisierung werden verschiedene Mechanismen vorgestellt, nämlich eine, wonach ein TFCI-Hard-Split-Modus verwendet werden würde, ein weiterer, wonach ein gesonderter Einsatz eines Transportformatsatzes (TFS) dazu verwendet werden würde, ein weitere Mechanismus, wonach ein gesonderter Transportkanal verwendet werden würde, ein noch weiterer Mechanismus, nach welchem ein Header pro Frame verwendet werden würde, und schließlich ein Mechanismus, wonach neue Zeitschlitzstrukturen mit einer In-Band-Signalisierung der Bitkategorie eingesetzt werden würde.

EP1014730 beschreibt ein FEC-Konzept für eine MPEG-2-Transportstromschicht, wobei die einzelnen TSP-Pakete um sogenannte Trailergroup-TSP-Pakete ergänzt werden, die mit spaltenweise erhaltenen Paritätsinformationen zu zeilenweise übereinander angeordneten TSP-Paketen versehen werden. Am Ende der Trailergroup-TSP-Pakete wird auch eine Information hinsichtlich der an den Erhalt der Paritätsinformationen beteiligten TSP-Pakete eingefügt.

Ausgehend von diesem Stand der Technik liegt der vorliegenden Erfindung die Aufgabe zugrunde, eine Möglichkeit für eine Verbesserung der Fehlerkorrektur bei aufgetretenen Übertragungsfehlern zu schaffen.

Diese Aufgabe wird durch den Gegenstand der unabhängigen Ansprüche gelöst.

Der vorliegenden Erfindung liegt die Erkenntnis zugrunde, dass eine Möglichkeit für einen gegenüber dem Stand der Technik verbesserten Fehlerschutz dadurch zu schaffen ist, dass einzelne Datensätze oder Datengruppen so mit einer zusätzlichen Informationen versehen werden, dass sie nach der Übertragung über einen Übertragungskanal in einem Empfänger wieder an der richtigen Stelle in einen Speicher einsortiert werden können, egal wie viele Datengruppen vorher fehlerhaft übertragen und/oder ganz verloren wurden. Hierzu wird einem Datensatz aus einer Mehrzahl von Datensätzen eine Versatzinformation zugewiesen, die angibt, wo in einer Speichereinrichtung eines Empfängers der entsprechende Datensatz eingeschrieben werden soll. Anschließend werden einer oder mehrere Datensätze und die dem entsprechenden Datensatz zugeordnete Versatzinformation ausgesendet.

Im Empfänger kann dann eine Mehrzahl von Datensätzen und eine einem Datensatz zugeordnete Versatzinformation empfangen werden, wobei durch die Kenntnis der Versatzinformation, die dem Datensatz zugeordnet ist, eine Möglichkeit besteht, den entsprechenden Datensatz an einer bestimmten Stelle in einem Speicher einzufügen. Somit lässt sich erkennen, dass ein Datensatz oder mehrere Datensätze bei der Übertragung verloren wurden oder fehlerbehaftet sind.

Durch eine derartige Vorgehensweise bietet sich daher der Vorteil, bei der Verwendung einer Vorwärtsfehlerkorrektur ein Fehlen oder falsches Eintragen von Datensätzen in dem Speicher zu erkennen und eine Fehlerkorrektur unter Berücksichtigung von korrekt in dem Speicher eingetragenen Daten durchführen zu können. Ferner bietet sich beim Senden der einem Datensatz zugewiesenen Versatzinformation die Möglichkeit, dass standardisierte und vorhandene Empfänger unter Umständen weiter verwendet werden können und neue Empfänger, die beispielsweise eine Möglichkeit zur Erkennung einer derartigen Versatzinformation aufweisen, von der verbesserten Möglichkeit der Vorwärtsfehlerkorrektur profitieren können.

Die vorliegende Erfindung wird nachfolgend anhand der beigefügten Zeichnungen näher erläutert. Es zeigen:

Fig. 1A     ein Blockschaltbild eines Vergleichsbeispiels des Senders;

Fig. 1B     ein Blockschaltbild eines Vergleichsbeispiels des Empfängers;

Fig. 2A     eine schematische Darstellung der Funktionsweise eines weiteren Vergleichsbeispiels des Senders;

Fig. 2B     eine schematische Darstellung der Funktionsweise eines weiteren Vergleichsbeispiels des Empfängers;

Fig. 3     eine Darstellung der Verwendung eines Speichers in einem weiteren Vergleichsbeispiels;

Fig. 4     eine Darstellung einer Verwendung von verschiedenen Teilspeichern in einem Ausführungsbeispiel der vorliegendend Erfindung;

Fig. 5     eine Darstellung zur exemplarischen Abschätzung des relativen Signalisierungsdatenüberhangs bei Aufteilung des Speichers in eine unterschiedliche Zahl von Teilspeichern gemäß verschiedenen Ausführungsformen der vorliegenden Erfindung;

Fig. 6     eine Darstellung zur Bildung von redundanten Zusatzinformationen gemäß einer Vorwärtsfehlerkorrekturvorschrift;

Fig. 7     eine Darstellung eines speziellen Aufbaus eines Datensatzes für die Übertragung von Fehlerkorrekturinformationen gemäß einem weiteren Beispiel;

Fig. 8     eine Darstellung der Aufteilung eines Nutzdatenanteils auf den Padding-Bereich zweier Datenpakete gemäß einem weiteren Ausführungsbeispiel;

Fig. 9     eine Darstellung eines falsch rekonstruierten MOT-Verzeichnisses; und

Fig. 10A und Fig. 10B  eine Darstellung der Wirkungsweise eines herkömm- lichen Interleavers auf die Fehlerkorrektureigen-schaften bei Verwendung eines Vorwärtsfehlerkorrektur-Algorithmus.

In den nachfolgenden Zeichnungen werden gleiche oder gleich wirkende Elemente mit gleichen oder ähnlichen Bezugszeichen versehen, wobei auf eine wiederholte Beschreibung dieser Elemente verzichtet wird.

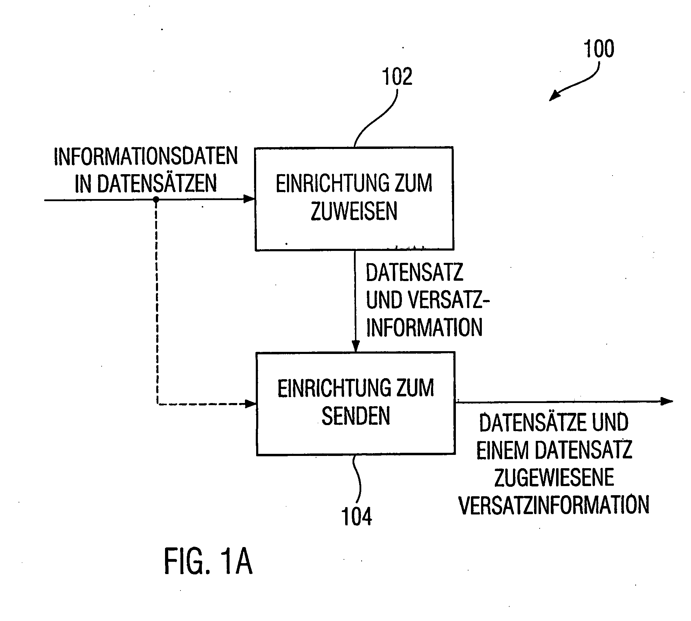

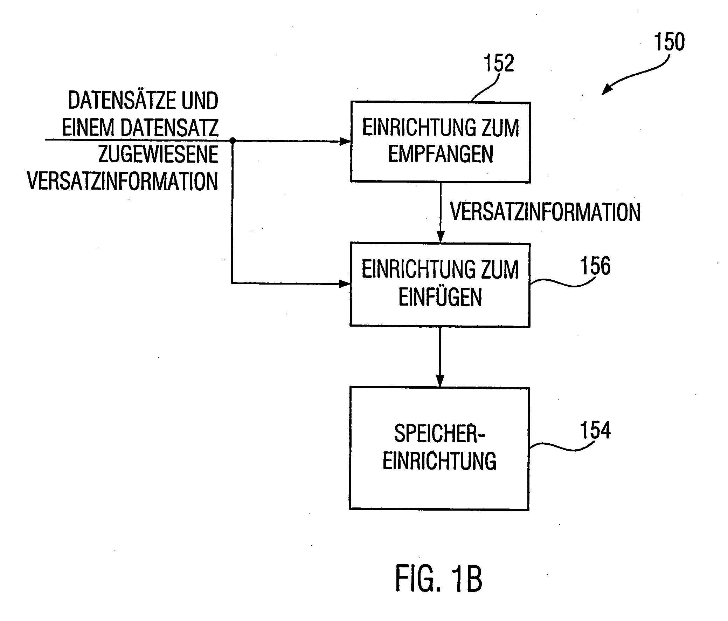

Fig. 1 zeigt einen Sender 100 zum Senden von Informationsdaten, die in einer Mehrzahl von Datensätzen vorliegen. Dabei weist der Sender 100 eine Einrichtung 102 zum Zuweisen einer Versatzinformation zu einem Datensatz der Mehrzahl von Datensätzen auf, wobei die Versatzinformation angibt, wo in einer Speichereinrichtung eines Empfängers der Datensatz eingeschrieben werden soll. Hierzu weist die Einrichtung 102 zum Zuweisen einen Eingang zum Empfangen von Informationsdaten in der Form von Datensätzen auf. Ferner weist die Einrichtung 102 zum Zuweisen einen Ausgang zum Ausgeben eines Datensatzes und/oder zum Ausgeben der Versatzinformation zu dem Datensatz auf. Diese Versatzinformation kann beispielsweise in einer Information über eine fortlaufende Nummerierung des Datensatzes, eine Information über die Größe des Datensatzes oder insbesondere auch eine Information über einen Offset sein, unter dessen Berücksichtigung der Datensatz in einem Speicher des Empfängers abgespeichert werden soll. Ferner weist der Sender 100 eine Einrichtung zum Senden 104 auf, die ausgebildet ist, um die Mehrzahl von Datensätzen und die dem Datensatz zugeordnete Versatzinformation zu senden. Hierzu weist die Einrichtung 104 zum Senden einen Eingang zum Empfangen der von der Einrichtung 102 zum Zuweisen ausgegebenen Versatzinformation und/oder des entsprechenden Datensatzes auf. Ferner weist die Einrichtung 104 zum Senden einen Ausgang zum Ausgeben (bzw. Senden) der Datensätze und der einem Datensatz zugewiesenen Versatzinformation auf. Optional kann die Einrichtung 104 zum Senden auch einen weiteren Eingang zum Empfangen der Informationsdaten in der Form von Datensätzen aufweisen, denen keine Versatzinformation zugewiesen ist.

Werden nun Informationsdaten in der Form von Datensätzen der Einrichtung zum Zuweisen 102 zugeführt, kann die Einrichtung zum Zuweisen beispielsweise durch die virtuelle Nachbildung eines im Empfänger vorhandenen virtuell nachgebildeten Speichers diejenige Versatzinformation einem Datensatz zuweisen, die angibt, an welcher Stelle der Datensatz in dem im Empfänger vorhandenen oder nachgebildeten Speicher eingetragen werden soll. Hierzu kann beispielsweise die Einrichtung 102 zum Zuweisen die Datensätze mit den Informationsdaten chronologisch in den Speicher oder den nachgebildeten Speicher einfüllen und dann diejenigen Speicheradressen, an denen eine Datensatzgrenze zwischen zwei Datensätzen auftritt, als Versatzinformation für den nächstfolgenden Datensatz ausgeben. Weiterhin kann zusätzlich die Versatzinformation auch eine Information über die Länge eines Datensatzes enthalten, so dass beispielsweise bei einem Verlust der Offset-Information noch aus der Information über die Länge des Datensatzes eine mögliche Offset-Position des nachfolgenden Datensatzes zurückgerechnet werden kann. Eine derartige Auslegung der Einrichtung 102 zum Zuweisen erhöht dann eine Robustheit gegenüber auftretenden Störungen bei der Übertragung. Weiterhin kann auch eine Durchnummerierung der Datensätze in der Einrichtung 102 zum Zuweisen erfolgen, wobei dann aus einer einfachen Ableseoperation diese Durchnummerierungskennzeichnung ersichtlich wird, wie viele Datenblöcke bzw. Datensätze nicht korrekt übertragen werden konnten. Allerdings ist hierbei anzumerken, dass dann eine Information über die Länge der Datensätze oder die Offset-Position nicht allein aus der Nummer eines verlorenen Datensatzes gefolgert werden kann.

Weiterhin kann auch die Versatzinformation mehrere Offset-Werte enthalten, wenn der Speicher ein mehrdimensionaler Speicher mit einer Dimension von größer als zwei ist.

Wird nun von der Einrichtung 102 zum Zuweisen der Datensatz und/oder die Versatzinformation zu dem entsprechenden Datensatz an die Einrichtung 104 zum Senden ausgegeben, kann diese den Datensatz und die Versatzinformation beispielsweise in einen Datenstrom aus mehreren Datensätzen einbetten und dann diesen Datenstrom aussenden.

Ferner kann auch die Einrichtung 104 zum Senden direkt Datensätze mit Informationsdaten erhalten und diese Datensätze zusammen mit dem einen Datensatz, der einer Versatzinformation zugewiesen wurde, in den Datenstrom einbetten. Hierdurch ist es möglich, einzelne Datensätze durch die den entsprechenden Datensätzen zugewiesenen Versatzinformation im Empfänger an einer entsprechenden Stelle in einen Speicher einzutragen, während zugleich andere Datensätze, die keine zugewiesene Versatzinformation enthalten, nicht in dem Speicher eingetragen werden. Bei der Benutzung eines derartigen Speichers im Empfänger für Fehlerkorrekturzwecke kann dann eine Skalierung der Fehlerkorrektur für die verschiedenen Datensätze erfolgen. Dies bedeutet dann, dass einzelne Datensätze, denen Versatzinformationen zugewiesen wurden, durch die Eintragung in dem Speicher besser schützbar sind als andere Datensätze, denen keine Versatzinformation zugewiesen wurde und die somit auch nicht in den Speicher eingetragen werden.

Der Sender weist ferner eine Einrichtung zum Ermitteln von Fehlerkorrekturdaten zur Korrektur eines Übertragungsfehlers in einem der Mehrzahl der Datensätze aufweisen, wobei die Einrichtung zum Ermitteln ausgebildet sein kann, um die Informationsdaten von Datensätzen gemäß einer Umsortierungsvorschrift umzusortieren und aus den umsortierten Informationsdaten die Fehlerkorrekturdaten zu ermitteln. Der Sender umfasst ferner eine Einrichtung zum Aussenden der Fehlerkorrekturdaten. Ein derartiger Sender ermöglicht somit eine Verbesserung der Fehlerkorrektureigenschaften, da nunmehr auch für eine Fehlerkorrektur verwendbare Fehlerkorrekturdaten ermittelt und ausgesendet werden können. Dies ermöglicht einem entsprechend ausgebildeten Empfänger, eine gegenüber dem Stand der Technik deutlich bessere Fehlerkorrektur durchzuführen.

Die Einrichtung zum Ermitteln kann ausgebildet sein, um das Umsortieren gemäß der Umsortierungsvorschrift derart auszuführen, dass die Informationsdaten gemäß einer Einschreibevorschrift in eine Speichereinrichtung eingelesen werden und die in der Speichereinrichtung gespeicherten Informationsdaten gemäß einer Auslesevorschrift ausgelesen werden, wobei sich die Einschreibevorschrift von der Auslesevorschrift unterscheidet. Ein derart ausgebildeter Sender weist den Vorteil auf, dass die Umsortierungsvorschrift durch einfache Einlese- und Ausleseoperationen in einen Speicher ausgeführt werden kann und nicht durch eine numerisch oder schaltungstechnisch aufwändig zu implementierende Umsetzungsvorschrift durchgeführt werden muss. Ein derartiges Umsortieren kann beispielsweise durch einen dem Fachmann bekannten Interleaver erfolgen, wobei die Einschreibevorschrift beispielsweise daraus besteht, in einem matrixförmigen Interleaverblock (als Speichereinrichtung) zeilenweise die Informationsdaten einzuschreiben und spaltenweise die in dem Interleaver gespeicherten Informationsdaten auszulesen.

In einem weiteren Ausführungsbeispiel des erfindungsgemäßen Senders kann die Speichereinrichtung eine Mehrzahl von Speicherzellen umfassen, die in einer Mehrzahl von Speicherzeilen und einer Mehrzahl von Speicherspalten angeordnet sind, wobei die Einrichtung zum Ermitteln ausgebildet sein kann, um Informationsdaten eines ersten Datensatzes der Mehrzahl von Datensätzen unter Verwendung einer ersten Anzahl von Speicherzellen un umzusortieren und um Informationsdaten eines zweiten Datensatzes der Mehrzahl von Datensätzen unter Verwendung einer zweiten Anzahl von Speicherzellen umzusortieren, wobei sich die erste Anzahl von Speicherzellen von der zweiten Anzahl von Speicherzellen unterscheiden kann. Ein derart ausgebildeter Sender bietet die Möglichkeit, dynamisch während dem Betrieb des Senders den Speicherbereich umzugestalten, um beispielsweise eine Anpassung an verschiedene Datensatzgrößen vorzunehmen. Dies ermöglicht unter Berücksichtigung von Overhead-Informationen für einen Datensatz eine Optimierung des Datendurchsatzes durch eine Optimierung der Speichergröße bzw. der Datensatzgröße im Verhältnis zur Overhead-Information für einen Datensatz.

Die Speichereinrichtung kann eine Mehrzahl von Teilspeichern aufweisen, wobei eine Anzahl von Speicherspalten oder eine Anzahl von Speicherzeilen der Speichereinrichtung oder des Teilspeichers von einer Anzahl von Informationsdaten in einem Datensatz abhängig sein kann. Eine derartige Ausgestaltung des Speichers bietet wiederum den Vorteil, eine weitere Optimierung des Verhältnisses zwischen Datensatzgröße und der für Signalisierungszwecke dem Datensatz anzufügenden Overhead-Informationen. Insbesondere durch die Verwendung von mehreren Teilspeichern, die beispielsweise unterschiedliche Größe (d.h. eine unterschiedliche Anzahl von Speicherzeilen oder Speicherspalten) aufweisen, ist es somit möglich bei Kanälen mit variabler Datenrate (beispielsweise bei der Übertragung mit unterschiedlich großen Datensätzen) für die verschiedenen Datensätze unterschiedlich große Teilspeicher verwenden zu können und somit die Datendurchsatzrate im Verhältnis zur Overhead-Größe zu optimieren.

Günstig ist es auch, wenn in einem weiteren Ausführungsbeispiel zum erfindungsgemäßen Sender eine Anzahl von Speicherspalten der Speichereinrichtung oder eines Teilspeichers mindestens der Anzahl von Informationsdaten desjenigen Datensatzes entspricht, der die größte Anzahl von Informationsdaten aufweist. Hierdurch wird vorteilhaft sichergestellt, dass ein Datensatz nicht länger als eine Zeile des Speichers sein kann und somit bei einem spaltenweisen Auslesen des Speichers ein gestörter bzw. nicht vorhandener Datensatz lediglich jeweils ein Symbol pro Speicherspalte betrifft. Ist die Länge der Speicherzeile zu gering, würde sonst ein Datensatz beispielsweise in die erste Zeile und die Hälfte der zweiten Zeile geschrieben, wobei dann ein Fehlen der Informationen des in dem Speicher abgelegten Datensatzes dazu führt, dass in der ersten Spalte zwei Informationssymbole fehlen, was die Korrigierbarkeit bei der Verwendung eines fehlerkorrigierenden Codes und je nach dessen aktuellen Konfiguration verringern kann.

Die Informationsdaten eines Datensatzes werden in nicht mehr als einen Teilblock eingeschrieben. Dieses bietet den Vorteil, dass sich eine Optimierung bzw. Verringerung der Verwaltungsinformationen ergibt, die einen Hinweis auf die in dem Teilblock gespeicherten Datensätze liefern. Wird nämlich ein Datensatz über mehrere Teilblöcke geschrieben, so ist in jedem Teilblock, in dem ein Teil des Datensatzes enthalten ist, ein Hinweis auf das Vorhandensein von Daten dieses Teilblocks abzulegen, so dass sich die Inhaltslisten der betroffenen Teilblöcke möglicherweise unnötig erweitern und somit die Overhead-Information unnötigerweise erhöht wird. Dies wiederum würde zu einer Reduktion der Datendurchsatzrate führen, da eine Erhöhung des Overheads bei gleichbleibender Kanalkapazität zu einer Verringerung der Nutzdatenrate führt.

Weiterhin kann in einem Ausführungsbeispiel des erfindungsgemäßen Senders die Einrichtung zum Ermitteln ausgebildet sein, die Fehlerkorrekturdaten auf der Basis einer EXKLUSIV-ODER-Verknüpfung zu ermitteln oder die Fehlerkorrekturdaten unter Verwendung eines Blockcode-Algorithmus zu ermitteln. Bei der Verwendung einer EXKLUSIV-ODER-Verknüpfung, um die Fehlerkorrekturdaten zu erhalten, bietet sich der Vorteil, dass durch diese EXKLUSIV-ODER-Verknüpfung eine numerisch oder schaltungstechnisch einfach auszuführende Möglichkeit zum Erhalt der Fehlerkorrekturdaten geboten wird. Allerdings lassen sich durch diese EXKLUSIV-ODER-Verknüpfung lediglich Paritätsbytes oder Paritätssymbole erzeugen, die in der Lage sind, einen einzigen Fehler in dem zu überwachenden Codewort zu korrigieren. Anders verhält es sich dabei bei der Verwendung eines (beispielsweise fehlerkorrigierenden) Blockcode-Algorithmus wie des Reed-Solomon-Algorithmus. Je nach verwendetem Fehlerkorrekturverfahren lassen sich gemäß dessen Codierungsvorschrift eine Vielzahl von Kombinationen von Nutzdaten- und Redundanzdatenanteil festlegen, wodurch eine flexible Skalierbarkeit der Fehlerkorrektureigenschaften ermöglicht wird.

Ferner ist die Einrichtung zum Aussenden ausgebildet, um die Versatzinformationen auszusenden. In diesem Fall würde die Einrichtung zum Aussenden in der Einrichtung zum Senden angeordnet sein und ermöglichen, dass die Versatzinformation gebündelt mit den Fehlerkorrekturdaten übertragen bzw. ausgesendet werden. Eine derartige Möglichkeit bietet den Vorteil, dass die Übertragung der Versatzinformation auch bei Anwendungen mit Übertragungsprotokollen möglich ist, die keine direkte Möglichkeit zum "Anhängen" der Versatzinformation an die Original-Datensätze bietet. Hierbei ist jedoch anzumerken, dass bei einer derartigen Möglichkeit eine Zwischenspeicherung der Datensätze, insbesondere unter Berücksichtigung der Datensatzgröße und der Datensatzposition in einem zu bildenden Datenstrom notwendig ist, um die beispielsweise nachträglich übertragene Vorwärtsfehlerkorrektur-Information auszuwerten und verwenden zu können.

Die Einrichtung zum Senden kann ausgebildet sein, um die Datensätze zu einem Datenstrom zusammenzufassen und die Fehlerkorrekturdaten in den Datenstrom einzufügen. Dies bietet den Vorteil, dass beispielsweise eine zur Übertragung der Informationsdaten der Datensätze in einem Übertragungsprotokoll vorhandene Rahmenstruktur ausgenutzt werden kann, um auch die Fehlerkorrekturdaten zu übertragen. In diesem Fall wäre lediglich eine geeignete Signalisierungsinformation, beispielsweise in einem Header des als Vorwärtsfehlerkorrekturdatensatzes verwendeten Rahmens notwendig.

Weiterhin ist es auch nicht erforderlich, die, beispielsweise unter Verwendung der Umsortierungsvorschrift, umsortierten Informationsdaten zu übertragen. Diese können lediglich zur Bildung der Fehlerkorrekturdaten verwendet werden, wobei dann nur die ermittelten Fehlerkorrekturdaten im Datenstrom übertragen werden. Dieses Prinzip eines "virtuellen" Interleavers bietet somit die Möglichkeit, dass nicht umsortierte Informationsdaten übertragen werden, sondern lediglich Zusatzinformationen unter deren Zuhilfenahme eine Verbesserung der Fehlerkorrektur möglich ist. Dies ermöglicht auch bereits vorhandene bzw. standardisierte Empfänger weiterverwenden zu können, ermöglicht jedoch zugleich auch die Implementierung einer verbesserten Fehlerkorrekturmöglichkeit bei neueren Empfängern. Hierzu ist jedoch sicherzustellen, dass die in einem entsprechend gekennzeichneten Rahmen eingetragenen Fehlerkorrekturdaten von einem herkömmlichen Empfänger verworfen oder ignoriert werden müssten und der herkömmliche Empfänger somit nicht durch die Übertragung der für neuere Empfänger bestimmten zusätzlichen Fehlerkorrekturdaten irritiert wird.

Die Einrichtung zum Senden ist ausgebildet, um die Datensätze einem oder mehreren (z.B. binären) Datenpaketen zuzuordnen, und dabei die einem Datensatz zugeordnete Versatzinformation in das dem Datensatz zugeordnete Datenpaket zu integrieren. Dies bietet die Möglichkeit, bereits auf Paketebene eine Information über die Versatzinformation, die einem Datensatz zugeordnet ist, zu übermitteln, wodurch es neueren Empfängern möglich wird, die empfangenen Datenpakete oder Datensätze bereits in einen entsprechend aufgebauten Speicher zu einer Fehlerkorrektur eintragen zu können. Eine derartige Möglichkeit zur schnellen Signalisierung des Vorhandenseins einer Versatzinformation zu einem Datensatz bietet somit eine Möglichkeit der weiteren Verbesserung der Fehlerkorrektureigenschaft (insbesondere der schnelleren Erkennbarkeit der Übermittlung von entsprechenden "Hilfsdaten") bei entsprechend ausgelegten Empfängern.

Weiterhin können auch gemäß einem bevorzugten Ausführungsbeispiel die Informationsdaten in einem ersten Datensatz und einen zweiten Datensatz vorliegen, wobei die Einrichtung 102 zum Zuweisen ausgebildet sein kann, um dem ersten Datensatz eine Versatzinformation zuzuweisen und dem zweiten Datensatz keine Versatzinformation zuzuweisen, und wobei die Einrichtung 104 zum Senden ferner ausgebildet sein kann, um den ersten Datensatz und den zweiten Datensatz zu senden. Dieses Ausführungsbeispiel entspricht dem in Fig. 1A dargestellten Beispiel unter Berücksichtigung der gestrichelten Linien, die dem Fluss von Datensätzen direkt in die Einrichtungen 104 zum Senden entspricht. Dies ermöglicht somit, dass einem Datensatz oder einigen Datensätzen entsprechende Versatzinformationen zugewiesen werden, während einem anderen Datensatz keine Versatzinformation zugewiesen wird. Hierdurch ergibt sich eine Möglichkeit, eine Skalierbarkeit einer entsprechenden Fehlerkorrekturfähigkeit für einzelne Typen von Datensätzen festzulegen. Diejenigen Datensätze, denen Versatzinformationen zugewiesen werden und die somit auch im Empfänger in einen entsprechenden Speicher eingetragen werden können, weisen damit eine bessere Möglichkeit für einen entsprechenden Fehlerschutz auf, als diejenigen Datensätze, denen keine Versatzinformation zugewiesen wurde, da diese Datensätze nicht in einen Speicher im Empfänger eingespeichert werden können.

Gemäß einem weiteren Ausführungsbeispiel der vorliegenden Erfindung kann ein erster Datensatz Informationsdaten einer ersten Aktualität und ein zweiter Datensatz Informationsdaten einer von der ersten Aktualität verschiedenen zweiten Aktualität aufweisen, wobei die Einrichtung 102 zum Zuweisen ausgebildet sein kann, dem ersten Datensatz eine erste Aktualitätsinformation zuzuweisen und dem zweiten Datensatz eine zweite Aktualitätsinformation zuzuweisen, und wobei die Einrichtung 104 zum Senden ausgebildet sein kann, um die erste Aktualitätsinformation und die zweite Aktualitätsinformation zu senden. Ein derart ausgebildeter Sender bietet den Vorteil, auch eine Information über die Aktualität der versendeten Datensätze mitzuübertragen, wodurch es einem entsprechend ausgebildeten Empfänger möglich ist, bei der Rekonstruktion auch die Aktualität der empfangenen Datensätze zu überprüfen und entsprechend bei dem Empfang eines neueren Datensatzes einen eventuell fehlerhaften älteren Datensatz nicht zu korrigieren bzw. die entsprechende Korrektur zu verwerfen.

Gemäß einem weiteren Ausführungsbeispiel der vorliegenden Erfindung kann die Einrichtung 104 zum Senden ausgebildet sein, um einen ersten Datensatz mit einer ersten Anzahl von Informationsdaten und einen zweiten Datensatz mit einer von der ersten Anzahl von Informationsdaten verschiedenen zweiten Anzahl von Informationsdaten zu senden. Dies ermöglicht die Verwendung von unterschiedlich großen Datensätzen, wodurch sich der Einsatzbereich eines derart ausgebildeten Senders gegenüber herkömmlichen Sendern erheblich erweitern lässt, insbesondere auf Anwendungen, die mit einer variablen Datenrate (beispielsweise einer variablen Datensatzgröße) arbeiten.

Ferner kann in einem weiteren Ausführungsbeispiel auch die Einrichtung zum Senden ausgebildet sein, um eine Information über eine Speicherspaltenanzahl oder eine Speicherzeilenanzahl des Speichers zu senden. Ein derart ausgebildeter Sender ermöglicht, dass eine Umkonfiguration eines Speichergröße bzw. eines Speicheraufbaus in einem entsprechend ausgebildeten Empfänger durchgeführt werden kann und somit über eine Art "Hilfskanal" dem Empfänger eine Information über die Dimensionierung des entsprechenden Speichers übertragen werden kann. Ein derart ausgebildeter Sender bietet somit den Vorteil einer deutlichen Flexibilisierung und ermöglicht somit auch eine deutliche Erhöhung des Einsatzbereichs.

Fig. 1B zeigt einen Empfänger 150 zum Empfangen von Informationsdaten, die in einer Mehrzahl von Datensätzen vorliegen und zum Empfangen einer einem Datensatz zugeordneten Versatzinformation, wobei die einem Datensatz zugeordnete Versatzinformation angibt, wo in einer Speichereinrichtung 154 der Datensatz eingespeichert werden soll. Der Empfänger 150 weist hierbei eine Einrichtung 152 zum Empfangen der Versatzinformation, die Speichereinrichtung 154 sowie eine Einrichtung 156 zum Einfügen eines Datensatzes in die Speichereinrichtung 154 an einer durch die Versatzinformation, die dem Datensatz zugeordnet ist, bestimmten Stelle auf. Die Einrichtung 152 zum Empfangen weist einen Eingang zum Empfangen eines Datensatzes einer einem Datensatz zugewiesenen Versatzinformation auf. Weiterhin weist die Einrichtung 152 zum Empfangen einen Ausgang zum Ausgeben der Versatzinformation auf. Die Einrichtung 156 zum Einfügen weist einen ersten Eingang zum Empfangen eines Datensatzes (bzw. von Datensätzen) auf. Ferner weist die Einrichtung 156 zum Einfügen einen zweiten Eingang zum Empfangen der Versatzinformation von der Einrichtung 152 zum Empfangen auf. Die Speichereinrichtung 154 weist einen Anschluss auf, über den die Einrichtung 156 zum Einfügen einen Datensatz an einer, durch die Versatzinformation, die dem Datensatz zugeordnet ist, bestimmten Stelle speichern kann.

Werden nun von dem Empfänger 150 ein Datensatz und eine einem Datensatz zugewiesene Versatzinformation empfangen, kann die Einrichtung 152 zum Empfangen die Versatzinformation extrahieren und der Einrichtung 156 zum Einfügen diese Versatzinformation zur Verfügung stellen. Die Einrichtung 156 zum Einfügen kann aus dem empfangenen Datensatz und der empfangenen Versatzinformation nunmehr den Datensatz an der durch die Versatzinformation bestimmten Stelle in der Speichereinrichtung 154 (d.h. dem Speicher) abspeichern. Durch die Kenntnis der Versatzinformation ist es beispielsweise möglich, den Verlust von einzelnen Datensätzen aus einem Datenstrom nunmehr zu erkennen und entsprechend bei der Abspeicherung der Datensätze in der Speichereinrichtung 154 zu berücksichtigen. Dies bietet eine Möglichkeit, um beispielsweise bei der Verwendung einer Vorwärtsfehlerkorrektur entsprechende Speichersegmente in der Speichereinrichtung 154 freizulassen und somit zu einer deutlichen Erhöhung der Wirksamkeit von übermittelten Fehlerkorrekturdaten bei einer Fehlerkorrektur beizutragen.

Der Empfängers weist eine Einrichtung zum Empfangen von Fehlerkorrekturdaten und eine Einrichtung zum Korrigieren eines Übertragungsfehlers in einem der Mehrzahl von Datensätzen auf, wobei die Einrichtung zum Korrigieren ausgebildet sein kann, um Informationsdaten von Datensätzen gemäß einer Umsortierungsvorschrift umzusortieren und aus den umsortierten Informationsdaten unter Verwendung der Fehlerkorrekturdaten den Übertragungsfehler korrigieren zu können. Eine derartige Ausgestaltung eines Empfängers bietet somit den Vorteil, zusätzlich zu den Datensätzen auch Fehlerkorrekturdaten empfangen zu können, wodurch sich somit eine gegenüber herkömmlichen Empfängern verbesserte Möglichkeit zur Fehlerkorrektur eines Übertragungsfehlers in einem Datensatz bereitstellen lässt.

In einem weiteren Ausführungsbeispiel der vorliegenden Erfindung kann die Einrichtung 156 zum Einfügen ausgebildet sein, um die Informationsdaten eines Datensatzes gemäß einer Einschreibevorschrift in die Speichereinrichtung 154 einzuschreiben, wobei die Einrichtung zum Korrigieren ferner ausgebildet ist, um die in der Speichereinrichtung 154 gespeicherten Informationsdaten gemäß einer von der Einschreibevorschrift verschiedenen Auslesevorschrift auszulesen. Dies bietet den Vorteil einer numerisch und schaltungstechnisch einfach zu implementierenden Umsortierungsvorschrift, beispielsweise in der Form eines Interleavers. Hierbei können dann bei der Ausbildung der Speichereinrichtung 154 in Form eines Blockinterleavers die Informationsdaten zeilenweise in den Blockinterleaver eingeschrieben werden, wobei die Einrichtung zum Korrigieren, die in dem Blockinterleaver gespeicherten Informationsdaten spaltenweise ausgelesen werden und hierdurch eine Umsortierung der Informationsdaten der verschiedenen Datensätze ermöglicht werden.

In einem weiteren Ausführungsbeispiel kann die Speichereinrichtung 154 eine Mehrzahl von Speicherzellen umfassen, die in einer Mehrzahl von Speicherzeilen und einer Mehrzahl von von Speicherspalten angeordnet sind, wobei die Einrichtung zum Korrigieren eine Einrichtung zum Verändern einer Anzahl von Speicherzellen umfasst, und wobei die Einrichtung zum Korrigieren ferner ausgebildet sein kann, um Informationsdaten eines ersten Datensatzes der Mehrzahl von Datensätzen unter Verwendung einer ersten Anzahl von Speicherzellen umzusortieren und um Informationsdaten eines zweiten Datensatzes der Mehrzahl von Datensätzen unter Verwendung einer zweiten Anzahl von Speicherzellen umzusortieren, wobei sich die erste Anzahl von Speicherzellen von der zweiten Anzahl von Speicherzellen unterscheiden kann. Dies ermöglicht die Verwendung einer Speichereinrichtung, die variabel konfigurierbar ist. Insbesondere kann beispielsweise durch die Anpassung einer Anzahl von Speicherspalten bei der Verwendung eines Blockinterleavers (d.h. bei einer variablen Länge einer Speicherzeile des Blockinterleavers) eine Anpassung an die Größe eines Datensatzes erfolgen, wodurch sich die Möglichkeit bietet, eine Optimierung des Datendurchsatzes durch eine Optimierung der Datenverarbeitung bei variabler Datensatzgröße bietet, und zugleich eine Optimierung des Verhältnisses zwischen Overhead- und Nutzdatenanteil eines Datensatzes durchführbar ist.

In einem weiteren Ausführungsbeispiel des Empfängers kann der Speicher eine Mehrzahl von Teilspeichern aufweisen, wobei eine Anzahl von Speicherspalten oder eine Anzahl von Speicherzeilen des Speichers oder des Teilspeichers von einer Anzahl von Informationsdaten in einem Datensatz abhängig sein kann. Dies ermöglicht weiterhin eine Optimierung des Datendurchsatzes durch eine Anpassung der Speicherzeilenanzahl des Speichers oder der Speicherspaltenanzahl des Speichers oder des Teilspeichers durch eine Möglichkeit zur Verbesserung des Verhältnisses von Overhead- zum Nutzdatenanteil in einem Datensatz. Ferner ist es auch hierdurch möglich, eine Optimierung der Datendurchsatzrate durch die Aufteilung der Speichereinrichtung 154 in verschiedene Teilspeicher durchführen zu können (unter Berücksichtigung einer Anpassung der Größe der Teilspeicher an die jeweils unterschiedlich großen Datensätze).

Günstig ist es auch, wenn eine Anzahl von Speicherspalten der Speichereinrichtung oder eines Teilspeichers mindestens der Anzahl von Informationsdaten desjenigen Datensatzes entspricht, der die größte Anzahl von Informationsdaten aufweist. Dies bietet den Vorteil, dass beispielsweise bei der Verwendung eines Blockinterleavers als Speichereinrichtung die Informationsdaten des Datensatzes vollständig in eine Speicherzeile eingebettet werden können und somit beispielsweise bei der Verwendung eines EXKLUSIV-ODERbasierten Vorwärtsfehlerkorrektur-Algorithmus eine verbesserte Korrekturmöglichkeit für diesen Datensatz bereitgestellt werden kann.

Weiterhin kann auch die Einrichtung 156 zum Einfügen ausgebildet sein, um die Informationsdaten eines Datensatzes in nicht mehr als einen Teilspeicher einzuschreiben. Dies bietet eine weitere Möglichkeit zur Optimierung des Datendurchsatzes durch eine verbesserte Möglichkeit, den Overhead zur Übertragung des in einem Teilblock gespeicherten Datensatzes gering zu halten.

Ferner kann die Einrichtung zum Korrigieren ausgebildet sein, um den Übertragungsfehler auf der Basis einer EXKLUSIV-ODER-Verknüpfung oder unter Verwendung eines Blockcode-Algorithmus zu korrigieren. Dies bietet den Vorteil, die Fehlerkorrektur auf der Basis von bereits bestehenden und somit ausreichend untersuchten Vorwärtsfehlerkorrektur-Algorithmen durchführen zu können, was eine erhebliche Erleichterung der Implementierung einer Möglichkeit zur Korrektur eines Übertragungsfehlers bietet.

Günstig ist es auch, wenn die Einrichtung zum Empfangen von Fehlerkorrekturdaten in der Einrichtung 152 zum Empfangen von Versatzinformationen ausgebildet ist. Dies bietet insbesondere dann einen Vorteil, wenn durch die Verwendung eines Übertragungsprotokolls, das keine Einbettung der Versatzinformationen in die zu übertragenden Datensätze zulässt, die Fehlerkorrekturinformationen gebündelt in einem eigenen Fehlerkorrekturdatensatz übertragen werden können und somit die Möglichkeit zur Verbesserung der Korrektureigenschaften eines derartigen Empfängers trotzdem aufrecht erhalten werden können. Dies bedingt jedoch einen zusätzlichen Zwischenspeicher, in dem die empfangenen Datensätze zwischengespeichert und nach Erhalt eines Fehlerkorrekturdatensatzes entsprechend in der Speichereinrichtung 154 eingefügt werden.

In einem weiteren Ausführungsbeispiel des erfindungsgemäßen Empfängers kann die Einrichtung zum Einfügen ausgebildet sein, um aus einem Datenstrom, der Datensätze und Fehlerkorrekturdaten umfasst, die Fehlerkorrekturdaten zu extrahieren. Dies bietet den Vorteil, keinen eigenen Datenstrom zur Übertragung der Fehlerkorrekturdaten bereitstellen zu müssen, sondern denjenigen Datenstrom nutzen zu können, der auch für die Übertragung der Informationsdaten der Datensätze verwendet wird. Hierzu können beispielsweise in vielen Übertragungsstandards frei verfügbare Datensatzkonfigurationen verwendet werden, die beispielsweise durch eine entsprechende Header-Signalisierung entsprechend markiert werden können.

In einem weiteren Ausführungsbeispiel können die Datensätze und die einem Datensatz zugeordnete Versatzinformation in einem oder mehreren (z.B. binären) Datenpaketen eingebettet sein, wobei die Einrichtung zum Empfangen der Versatzinformation ausgebildet ist, um die Versatzinformation, die einem Datensatz zugeordnet ist, aus dem einem Datenpaket oder den Datenpaketen zu extrahieren. Dies bietet den Vorteil, dass beispielsweise auf unteren Protokollschichten, auf denen Datenpakete mit den Informationsdaten der Datensätze übertragen werden, die Versatzinformationen eingebettet und somit zeitnah zu den Datensätzen übertragen werden können. Insbesondere dann, wenn in diesen binären Datenpaketen auf niedrigeren Protokollschichten noch für weitere Daten frei verfügbare Übertragungskapazität vorhanden ist, bietet eine derartige Möglichkeit einen Vorteil in Bezug auf die Bandbreiteneffizienz bereits bestehender Systeme.

In einem weiteren Ausführungsbeispiel des erfindungsgemäßen Empfängers können Informationsdaten in einem ersten Datensatz und in einem zweiten Datensatz vorliegen, wobei dem ersten Datensatz eine Versatzinformation zugeordnet ist und dem zweiten Satz keine Versatzinformation zugeordnet ist, und wobei die Einrichtung 156 zum Einfügen ausgebildet ist, um den ersten Datensatz an der durch die dem ersten Datensatz zugeordnete Versatzinformation bestimmten Stelle in der Speichereinrichtung 154 einzufügen und den zweiten Datensatz nicht in die Speichereinrichtung 154 einzufügen. Dies bietet den Vorteil, ein in Bezug auf die Fehlerkorrektureigenschaften der unterschiedlichen Datensätze flexibel auszugestaltendes Übertragungssystem zu schaffen. Beispielsweise können die Informationsdaten im ersten Datensatz dann durch das Eintragen an der bestimmten Stelle in der Speichereinrichtung 154 besser geschützt werden als die Informationsdaten des zweiten Datensatzes, die nicht in die Speichereinrichtung 154 eingefügt werden.

In einem weiteren Ausführungsbeispiel des erfindungsgemäßen Empfängers können in einem ersten Datensatz Informationsdaten mit einer ersten Aktualitätsinformation und in einem zweiten Datensatz Informationsdaten mit einer von der ersten Aktualitätsinformation verschiedenen zweiten Aktualitätsinformation vorliegen, wobei die zweite Aktualitätsinformation auf eine höhere der Aktualität der Informationsdaten des zweiten Datensatzes gegenüber der durch die erste Aktualitätsinformation bezeichneten Aktualität der Informationsdaten des ersten Datensatzes hinweist, und wobei die Einrichtung zum Korrigieren ausgebildet ist, um einen Übertragungsfehler im ersten Datensatz nicht zu korrigieren und einen Übertragungsfehler im zweiten Datensatz zu korrigieren. Dies bietet den Vorteil, dass bei der Verwendung eines Datenkarussells zur Übertragung der Informationsdaten eine Aktualisierung der Informationsdaten erkannt werden kann und somit eine Korrektur eines Datensatzes mit veralteten Informationsdaten unterbleibt wodurch eine Störung der Gesamtübertragung vermieden wird.

Weiterhin kann auch der Empfänger ausgebildet sein, um einen ersten Datensatz mit einer ersten Anzahl von Informationsdaten und einen zweiten Datensatz mit einer von der ersten Anzahl von Informationsdaten verschiedenen zweiten Anzahl von Informationsdaten zu empfangen. Dies bietet den Vorteil der Einsatzmöglichkeit eines derart ausgestalteten Empfängers in Szenarien mit variabler Datensatzgröße und somit auch variabler Übertragungsrate oder variable Paketdatengröße verarbeiten zu können und somit beispielsweise für Audio- oder Videoanwendungen besonders günstig geeignet zu sein.

Günstig ist es auch, wenn die Einrichtung zum Korrigieren ferner ausgebildet ist, um eine Information über eine Speicherspaltenanzahl oder eine Information über eine Speicherzeilenanzahl der Speichereinrichtung 154 zu empfangen und die Speichereinrichtung in Abhängigkeit von der empfangenen Speicherzeilenanzahl oder der empfangenen Speicherspaltenanzahl zu verändern. Ein derart ausgestatteter Empfänger bietet die Möglichkeit, beispielsweise unter Verwendung eines Nebenkanals zur Übertragung von Verwaltungsinformationen, flexibel eine Variation der Größe der Speichereinrichtung 154 oder des Aufbaus der Speichereinrichtung 154 zu verändern und somit flexibel auf sich ändernde Übertragungsszenarien reagieren zu können.

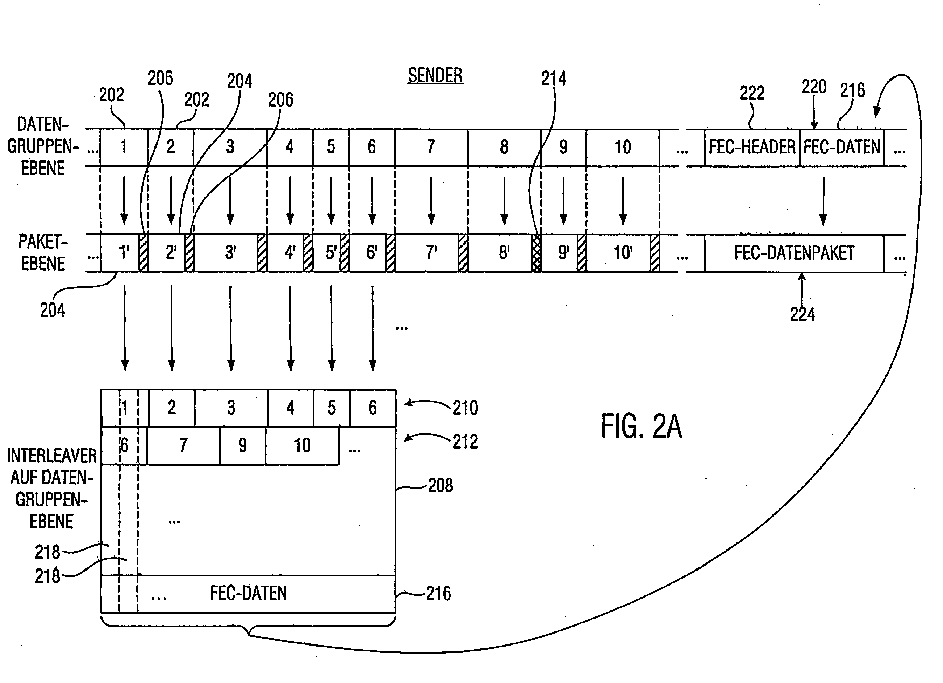

In Fig. 2A ist schematisch der Ablauf der Datenverarbeitung dargestellt. Hierbei liegen zunächst die Informationsdaten in verschiedenen Datengruppen 202 vor, wobei die einzelnen Datengruppen 202 auf Datengruppenebene durchgehend von 1 bis 10 nummeriert sind. Hierbei ist anzumerken, dass die einzelnen Datengruppen 202 unterschiedliche Länge aufweisen können. Die einzelnen Datengruppen können auf Paketebene transferiert werden, wobei die Paketebene beispielsweise eine im OSI-Systemmodell (OSI = Open System Interconnection) niedrigere Übertragungsschicht (beispielsweise die physikalische Schicht oder die DataLink-Schicht) sein kann. Diese Datenpakete können beispielsweise binäre Datenpakete sein oder in Bytes gruppiert sein. In Fig. 2A sind derartige Datenpakete durch das Bezugszeichen 204 bezeichnet, wobei zur besseren Unterscheidung zwischen der Datengruppenebene und der Paketebene die Datenpakete fortlaufend durch die Nummern 1' bis 10' gekennzeichnet sind. Hierbei ist anzumerken, dass die Datenpakete 204 gleiche Längen wie die Datengruppen 202 aufweisen oder aber auch unterschiedliche Längen haben können. Ferner ist in Fig. 2A dargestellt, dass die Datenpakete 204 einen Hilfsbereich 206 enthalten, der beispielsweise in herkömmliche Übertragungsschichten für Nutzdaten nicht verwendet wird (und beispielsweise durch den binären Wert "0" gekennzeichnet ist). Dieser, für herkömmliche Übertragungsprotokolle nicht verwendete Hilfsbereich 206 kann erfindungsgemäß beispielsweise dazu verwendet werden, die Versatzinformation direkt auf Paketebene mit den Informationsdaten des entsprechenden Datensatzes zu kombinieren. Derart aufbereitet werden dann die Datenpakete 204 mit den Versatzdaten in dem Hilfsbereich 206 über die in Fig. 1A dargestellte Einrichtung 104 zum Senden übertragen. Parallel hierzu können beispielsweise in der Form eines "virtuellen" Interleavers die Datengruppen 202 oder die Informationsdaten der in den Datenpaketen 204 eingebetteten Nutzdaten in einen Interleaver 208 zeilenweise eingelesen werden. Wie in Fig. 2A dargestellt ist, können somit in einer Speicherzeile des Interleavers 208, der beispielsweise der Speichereinrichtung 154 in Fig. 1B entspricht oder dieser nachgebildet wurde, mehrere Datensätze oder Informationsdaten von mehreren Datensätzen eingelesen werden. Hierbei kann die Länge einer Speicherzeile des Interleavers 208 variabel sein, sollte jedoch zumindest so lang sein, dass ein einzelner Datensatz nicht über mehr als eine Zeile hinausreicht. In Fig. 2A ist die Zeilenlänge der ersten Zeile 210 des Interleavers 208 derart gewählt, dass die ersten fünf Datensätze und ein Teil des sechsten Datensatzes darin gespeichert werden können. In der zweiten Zeile 212 des Interleavers 208 sind dann der zweite Teil des sechsten Datensatzes und die Datensätze sieben, neun und zehn gespeichert. Hierbei ist anzumerken, dass der achte Datensatz in der Datengruppenebene beispielsweise allzu lang für eine Speicherung in dem Interleaver 208 wäre und entsprechend gekennzeichnet ist und keine Versatzinformation diesem achten Datensatz zugewiesen wird. Dies kann dann beispielsweise in dem Hilfsbereich 206 des achten Datensatzes 8 bzw. dem achten Datenpaket 8' markiert sein. Beispielsweise in der Form, dass dieser Hilfsbereich 214 die aus herkömmlichen Übertragungsprotokollen bekannte Signalisierung aufweist. Hierdurch kann dann ein entsprechend ausgebildeter Empfänger auch erkennen, dass der achte Datensatz nicht in einen Speicher bzw. Interleaver eingetragen werden darf und somit eine nachfolgende Fehlerkorrektur keine Fehler im achten Datensatz 8 korrigieren kann.

Sind nun die einzelnen zu korrigierenden Datensätze entsprechend in den Interleaver 208 eingetragen worden, können beispielsweise durch ein spaltenweises Auslesen der einzelnen Spalten des Interleavers 208 die FEC-Daten 216 für jede Spalte 218 des Interleavers 208 berechnet werden. Diese FEC-Daten 216 können dann als eigene Datengruppe in der Datengruppenebene eingefügt werden. Dabei kann beispielsweise ein spezieller FEC-Header 222 zur Kennzeichnung dieser FEC-Datengruppe mit den FEC-Daten 216 verwendet werden. Entsprechend kann auch diese FEC-Datengruppe 220 über die Paketebene als entsprechendes FEC-Datenpaket 224 übertragen werden.

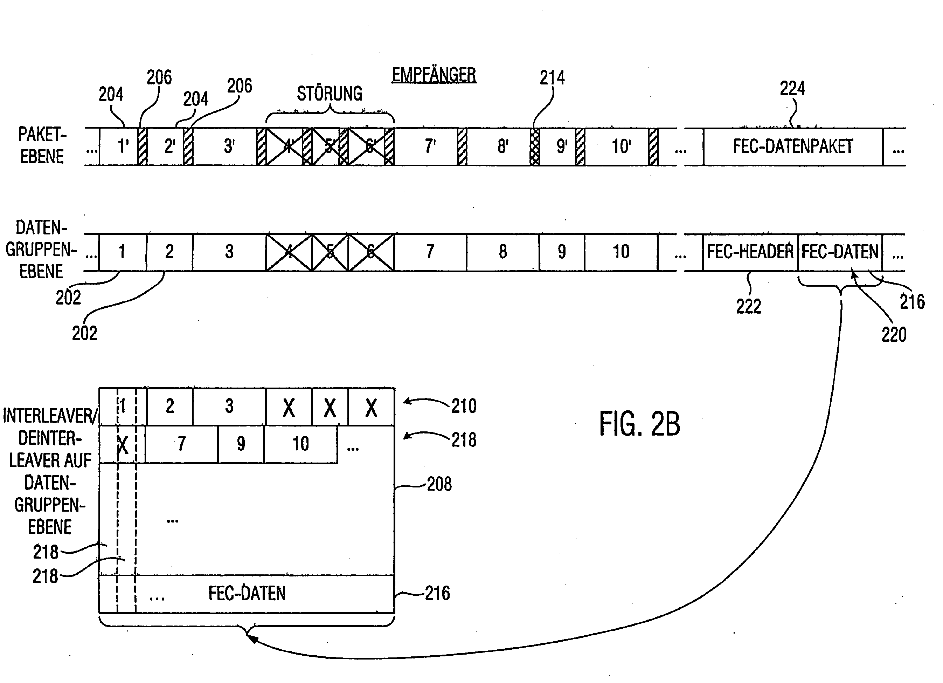

Fig. 2B zeigt einen entsprechend aufgebauten Empfänger. Hierbei werden wieder auf Paketebene die Datenpakete 204 mit den Hilfsbereichen 206 empfangen. Entsprechend der Fig. 2A werden die einzelnen Datenpakete zur besseren Unterscheidung gegenüber den Datensätzen mit 1' bis 10' gekennzeichnet.

Tritt nun bei der Übertragung der Datenpakete über einen Übertragungskanal beispielsweise eine burstartige Störung auf, werden einzelne Bits oder Bytes in den Datenpaketen verändert. Dies kann beispielsweise durch eine Fehlerschutzerkennung auf der Basis eines CRC-Verfahrens (CRC = Cyclic Redundancy Check) erfolgen, wobei entsprechende CRC-Daten beispielsweise ebenfalls im Hilfsbereich 206 der einzelnen Datenpakete übertragen werden können. Wird nun auf Paketebene eine Störung, insbesondere eine burstartige Störung, durch die Auswertung der CRC-Daten erkannt, wird in vielen Übertragungsprotokollen das gesamte Datenpaket verworfen, um keine fehlerhaften Daten einer Applikation weiterzugeben. In Fig. 2B ist eine derartige Störung exemplarisch für die Datenpakete 4', 5' und 6' gekennzeichnet, wobei dann auch auf der entsprechenden Datengruppenebene durch die verworfenen Datenpakete 4', 5' und 6' die entsprechenden Datengruppen 4, 5 und 6 verworfen werden.

Weist nun der Empfänger jedoch eine Speichereinrichtung wie beispielsweise den in Fig. 2B dargestellten Blockinterleaver 208 auf, können jedoch parallel zum Empfang die empfangenen Datengruppen oder die in den Datengruppen enthaltenen Informationsdaten entsprechend einer Umsortierungsvorschrift in den Blockinterleaver 208 eingetragen werden. Dies erfolgt vorzugsweise gemäß einer Umsortierungsvorschrift, die auch dem in einem "virtuellen" bzw. "virtuell" nachgebildeten Interleaver im Sender entspricht, wie es in Fig. 2A dargestellt ist. Hierbei kann dann beispielsweise ein zeilenweises Einlesen der empfangenen Datengruppe erfolgen, wobei durch die in den Hilfsbereichen 206 übertragene Versatzinformation ausgewertet werden kann und die angibt, an welcher Stelle der empfangene Datensatz entsprechend den Versatzinformationen in dem Blockinterleaver 208 einzutragen ist. Dies ermöglicht somit ein Erkennen von fehlenden Datensätzen. Sind nun beispielsweise Datensätze 4, 5 und 6 aufgrund fehlerhafter Datenübertragung und der Fehlererkennung verworfen worden, kann der Datensatz 7 an der für den Datensatz 7 vorgesehenen Stelle im Interleaverblock eingetragen werden. Dies ermöglicht somit ein "Freilassen" derjenigen Speicherbereiche, in die die verworfenen Datensätze hätten eingetragen werden sollten.

Durch den nachfolgenden Empfang der FEC-Datengruppe 220 können nun die darin enthaltene FEC-Daten 216 verwendet werden, um einzelne Fehler in den Spalten 218 des Blockinterleavers 208 korrigieren zu können. Hierbei wird auch ersichtlich, dass die Länge einer Interleaverzeile nicht kürzer als die Länge einer Datengruppe sein sollte, da ansonsten eine Datengruppe über mehr als eine Interleaverzeile reichen würde und bei einem Verlust einer solchen Datengruppe und der Korrektureigenschaft der FEC-Daten von nur einem Symbol pro Spalte eine Wiederherstellung der Datengruppe möglich wäre.

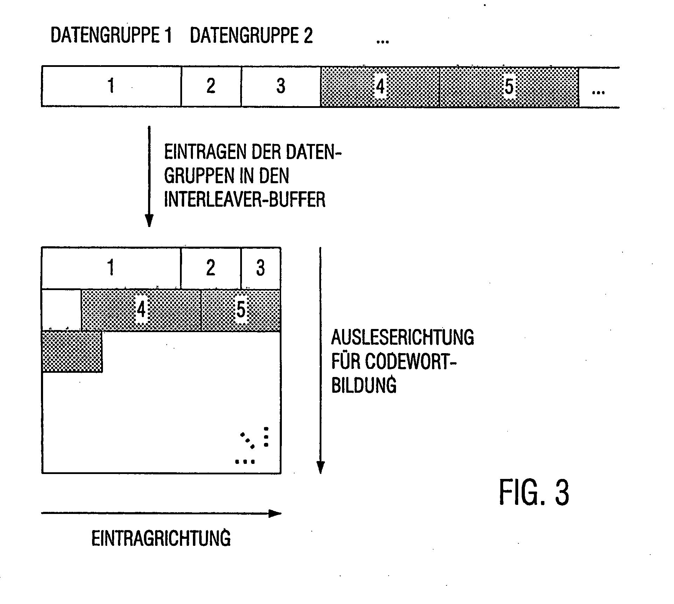

Wie auch aus Fig. 2B ersichtlich ist, kann durch einen entsprechende Codierer des Hilfsbereichs 214 des achten Datenpakets 8' auch markiert werden, dass der achte Datensatz 8 nicht vom Fehlerschutz erfasst werden soll und damit nicht in den Blockinterleaver 208 eingetragen werden soll (beispielsweise weil der Datensatz 8 eine Größe aufweist, die größer als eine maximale, beispielsweise hardware-bedingte Größe einer Speicherzeile des Blockinterleavers 208 ist). Zum Entwurf eines Blockinterleavers, wie beispielsweise dem in den Fig. 2A und 2B dargestellten Blockinterleaver 208, kann ferner angemerkt werden, dass dieser so aufgeteilt werden sollte, dass seine Zeilenanzahl der Anzahl der Nachrichtensymbole in einem FEC-Codewort entspricht. Ein solcher Blockinterleaver ist beispielsweise in Fig. 3 dargestellt.

Die MSC-Datengruppe (d.h. die Datensätze) der zu schützenden Datendienste werden bei der Zwischenspeicherung zeilenweise in den Puffer eingetragen. Wenn der Puffer gefüllt ist (die nächste MSC-Datengruppe kann nicht mehr komplett eingefügt werden), wären dann mittels eines geeigneten FEC-Algorithmus spaltenweise die Redundanzsymbole gebildet. Das durch die Kombination von zeilenweisem Eintragen der MSC-Datengruppen und spaltenweisem Auslesen für die Codewortbildung entstehende Interleaving weist eine große Interleaving-Distanz von der Länge einer Pufferblockzeile auf, die länger als die größte zu schützende MSC-Datengruppe sein muss (abhängig vom Datendienst, aber durch die maximale Größe der MSC-Datengrupppen beschränkt).

Bei Verlust einer MSC-Datengruppe während der Übertragung ist so jeweils nur ein Symbol pro Codewort (Spalte) zerstört. Die verlorene MSC-Datengruppe kann rekonstruiert werden. Da normalerweise viele MSC-Datengruppen hintereinander in einer Pufferzeile liegen, können mit diesem Interleaver-Aufbau auch Burstfehler, die mehrere aufeinander folgende MSC-Datengruppen zerstören würden, behoben werden.

Um empfangsseitig den inversen FEC-Algorithmus zur Wiederherstellung einer verlorenen MSC-Datengruppe ausführen zu können, ist kann es nötig sein, dass die korrekt empfangenen MSC-Datengruppen im Empfangspuffer an der gleichen Stelle eingetragen werden wie auf der Sendeseite. Dazu sollte die Adresse der MSC-Datengruppe im Puffer zusammmen mit jeder MSC-Datengruppe übertragen werden, vorzugsweise in Form der oben angeführten Versatzinformation.

Für eine einfache Rekonstruktion ist es günstig, dass empfangsseitig erkannt werden kann, welche MSC-Datengruppen innerhalb des Puffers (aufgrund von Empfangsfehlern) nicht empfangen werden konnten. Um dies zu gewährleisten, sollten zusätzliche Informationen zusammen mit den FEC-Daten übertragen werden. Am effizientesten können diese Informationen in Form sogenannter Adressierungsinformationen übertragen werden. Dabei wird zusammen mit den FEC-Daten die Adresse jeder MSC-Datengruppe des Sendepuffers ausgestrahlt.

Der Vorteil eines Blockinterleavers liegt neben der großen Interleavings-Distanz, die auch eine Korrektur von Burstfehlern erlaubt, in der einfachen Adressierung. Die genaue Adresse der einzelnen MSC Datengruppen innerhalb des Puffers ist empfangsseitig für die Dekodierung wichtig und kann bei einem einfachen Blockinterleaver durch den Offset innerhalb des Puffers und die Länge der MSC-Datengruppen angegeben werden.

Es ist jedoch zu beachten, dass sich die Größe des Puffers auf die Dauer zwischen den Rekonstruktionszyklen auswirkt, da der Puffer immer erst vollständig gefüllt werden sollte, bevor auf Sendeseite die Bildung der redundanten Korrekturinformationen erfolgen kann, bzw. die Rekonstruktion fehlender MSC-Datengruppen auf Empfangsseite vorgenommen werden kann. Dies kann auf Empfangsseite Verzögerungen bewirken und beeinflusst den Qualitätseindruck des Nutzers. Allerdings können fehlerfrei empfangene MSC-Datengruppen sofort verwendet werden, lediglich fehlerbehaftete (und damit eigentlich verlorene) MSC-Datengruppen werden mit einer Verzögerung rekonstruiert.

Weiterhin ist die Menge der berechneten FEC-Daten und Adressierungsdaten der MSC-Datengruppen im Puffer zu berücksichtigen. Die FEC-Daten lassen sich oftmals nicht mehr in einer einzigen MSC-Datengruppe übertragen, da MSC-Datengruppen oftmals eine maximale Größe vorgegeben ist. Daher kann es erforderlich sein, die Adressierungsdaten auf mehrere MSC-Datengruppen aufzuteilen. Dabei sollte für eine einfache Rekonstruktion jedoch jede dieser FEC-Datengruppen sämtliche Adressdaten aller MSC Datentgruppen im Puffer beinhalten, so dass der Overhead (Datenüberhang auf Grund von Signalisierungsinformationen) jedoch steigt.

Diese Aspekte des einfachen Blockinterleavers bezüglich Zeitverzögerung und Menge der anfallenden Verwaltungsinformationen werden durch eine Weiterentwicklung gemäß einem Ausführungsbeispiel beseitigt.

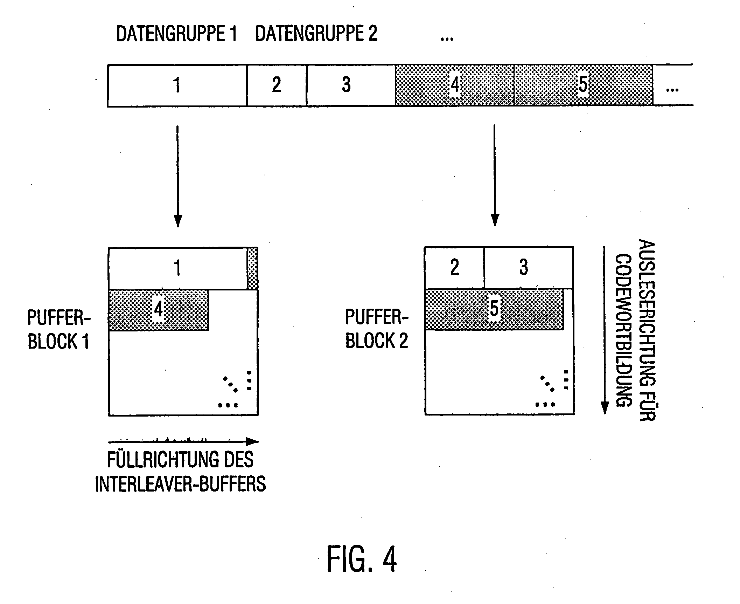

Bei diesem Ausführungsbeispiel wird ein erweiterter Blockinterleaver verwendet, bei dem für die Zwischenspeicherung der MSC-Datengruppen für die FEC-Berechnung verwendeten Speicherbereich nicht als zusammenhängend betrachtet, sondern, wie in Fig. 4 exemplarisch dargestellt, in mehrere Blöcke unterteilt wird.

Die MSC-Datengruppen werden für die Zwischenspeicherung nacheinander in die einzelnen Pufferblöcke eingetragen. Dabei werden eine oder mehrere aufeinander folgende MSC-Datengruppen so lange zeilenweise in denselben Pufferblock geschrieben, dass ihre Gesamtlänge die Länge einer Pufferblockzeile nicht überschreitet, da sonst im Fall von Burstfehlern die maximale Interleaving-Distanz nicht mehr gegeben wäre. Diese maximal mögliche Interleaving-Distanz hat den Wert Zeilenlänge mal Blockanzahl.

Auch hier erfolgt das Auslesen für die Codewortbildung und die FEC-Berechnung wieder orthogonal zur Richtung des Einschreibens der MSC-Datengruppen.

Durch die Zeilenlänge ist vorzugsweise die maximal zu schützende MSC-Datengruppengröße vorgegeben. MSC-Datengruppen, die länger als eine Pufferblockzeile sind, können beispielsweise nicht in den Puffer eingetragen und damit nicht vor Fehlern geschützt werden. Alternativ können aber auch andere Datengruppen, die beispielsweise niedrigpriorisierte Daten enthalten, so markiert werden, dass sie vom FEC-Fehlerschutz ausgeschlossen werden. Somit lässt sich eine variable Skalierbarkeit des Fehlerschutzes bereitstellen, die je nach Anforderung des Datendienstes nach hohem oder niedrigem Fehlerschutz eine entsprechende Eintragung in den Blockinterleaver ermöglicht. Dies bietet den zusätzlichen Vorteil einer freien Skalierbarkeit und somit einer Erhöhung der Flexibilität der Einsatzmöglichkeit eines entsprechend ausgebildeten Senders bzw. Empfängers.

Da die FEC-Berechnung für jeden Pufferblock vorzugsweise getrennt erfolgt, werden häufiger FEC-Daten versendet, häufiger FEC-Berechnungen durchgeführt (aber auf kleineren Pufferblöcken) und die Verzögerung auf Empfangsseite bis zur ersten möglichen Rekonstruktion wird zusätzlich etwas reduziert. Dies resultiert vor allem daraus, dass die FEC-Daten gleichmäßiger in den Datenstrom eingefügt werden.

Bei der Entscheidung für eine der beiden vorgestellten Interleaver-Aufbauarten (einfacher beziehungsweise erweiterter bzw. geteilter Blockinterleaver) sind drei wichtige Kriterien zu beachten. Erstens sollte der entwickelte Interleaver, entsprechend den oben dargestellten Voraussetzungen, die Korrektur möglichst großer Burstfehler auf MSC-Datengruppenebene ermöglichen. Zweitens sollte die zeitliche Verzögerung, die durch das Zwischenspeichern der MSC-Datengruppen für die FEC-Datenbildung entsteht, minimiert werden, um den Qualitätseindruck des Nutzers zu steigern. Drittens sollte der durch den FEC-Algorithmus entstehende Overhead (Overhead durch die redundanten FEC-Daten und zusätzlich benötigten Informationen wie z.B. die Adressierungsdaten bzw. Versatzdaten) beachtet werden. Viertens sollte die Größe der zu schützenden MSC-Datengruppen berücksichtigt werden.

Da die Interleaving-Distanz (also die maximal mögliche zu korrigierende Burstfehlerlänge), bei beiden Interleaver-Typen bei gleicher Gesamtspeichergröße nahezu gleich ist, würde die Gesamtspeichergröße für die nachfolgende exemplarische Darstellung immer zu 64 Kilobyte gewählt.

Bei dieser Wahl liegt die maximal zu korrigierende Burstfehlerlänge auf MSC-Datengruppenebene bei 12 MSC-Datengruppen, wenn die MSC-Datengruppengröße mit 500 Byte angenommen wird.

Es wurden jeweils für den einfachen Blockinterleaver (Puffergröße 64 Kilobyte) wie auch für den erweiterten Blockinterleaver (in der nachfolgenden Simulation mit 10 Pufferblöcken zu je 6400 Byte) zwei Möglichkeiten simuliert.

Zum einen eine Übertragung sämtlicher zusätzlicher FEC-Symbole und Verwaltungsinformationen in einer einzigen FEC-Datengruppe (d.h. einem einzigen FEC-Datensatz) und zum anderen die Übertragung in FEC-Datengruppen, die in etwa die gleiche Größe wie die zu schützenden MSC Datengruppen aufweisen. Ausgegangen wurde bei der Simulation von einem Fehlerschutz mit einem zusätzlichen, redundanten Korrektursymbol pro 10 Nachrichtensymbolen, so dass der reine FEC-Overhead 10% betrug.

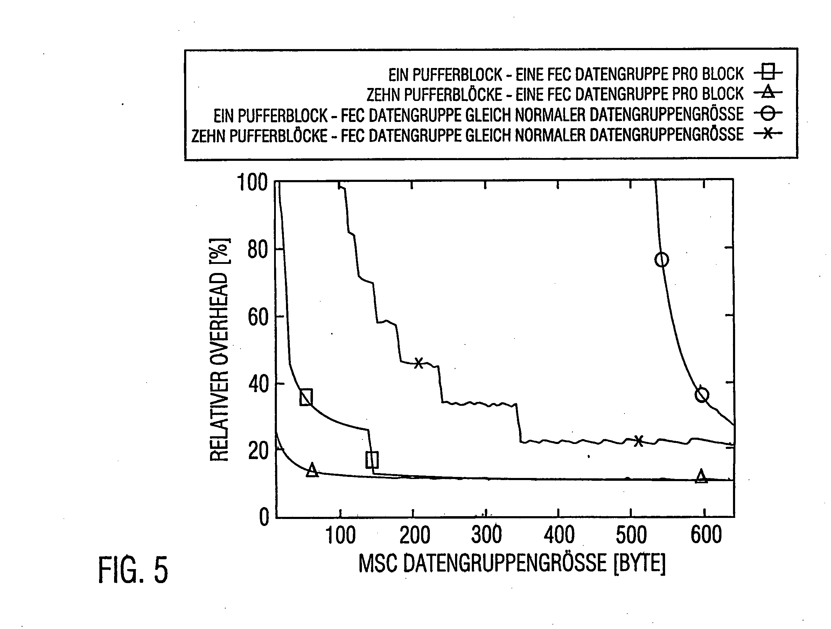

Fig. 5 zeigt die Simulationsergebnisse der vorstehend beschriebenen Simulation. Aufgetragen ist der relative Overhead, also die Größe der zusätzlich nötigen Verwaltungsinformationen (z.B. die Adressierungsinformationen) und der FEC-Daten bezogen auf die Größe der übertragenen Nutzdaten, aufgetragen über der Größe der zu schützenden MSC-Datengruppen.

Deutlich zeigt sich, dass bei der Wahl eines einfachen Blockinteleavers mit mehreren FEC-Datengruppen (die alle die kompletten Adressierungsdaten aller im Puffer enthaltenen MSC-Datengruppen enthalten sollten) der Overhead im Vergleich zu den anderen Kurven sehr hoch ist, wie aus der mit einem Kreuz näher gekennzeichneten Linie in Fig. 5 ersichtlich ist. Gleiches gilt für eine Anordnung aus 10 Pufferblöcken und mehreren FEC-Datengruppen pro Pufferblock, deren Größe den zu schützenden MSC-Datengruppen entspricht (siehe die Fig. 5 mit einem Kreuz dargestellte Linie).

Auch zeigt die Grafik den Aspekt, dass die Verwaltungsinformationen und die FEC-Daten zu groß für eine FEC-Datengruppe werden können. In diesem Fall müssten sie auf mehrere MSC-Datengruppen aufgeteilt werden. In der Grafik zeigt diesen Umstand die mit einem Rechteck gekennzeichnete Linie des einfachen Blockinterleavers mit einer FEC-Datengruppe pro Pufferblock besonders deutlich. Für MSC-Datengruppengröße von ≤150 Bytes übersteigen die anfallenden Adressierungsinformationen und die FEC-Daten die Nettodatengruppengröße. Eine zweite FEC-Datengruppe muss gebildet werden, wodurch der Overhead steigt.

An der zu dem erweiterten Blockinterleavers mit einer FEC-Datengruppe pro Pufferblock gehörigen Linie (durch ein Dreieck in Fig. 5 gekennzeichnet) ist gut zu erkennen, dass der Overhead für die Verwaltungsinformationen und die FEC-Daten (bei Verwendung eines FEC-Algorithmus mit einem Korrektursymbol pro zehn Nachrichtensymbolen) relativ niedrig und konstant bei 11% liegt. In einer weiteren durchgeführten Simulation konnte gezeigt werden, dass dieser Wert nahezu unabhängig von der Anzahl der verwendeten Pufferblöcke ist.

Der zeitliche Gewinn durch diese FEC-Implementierung und die damit für den Nutzer gestiegene Qualität des Datendienstes wird anhand eines Beispiels deutlich:

Der Datendienst einer Broadcast-Website mit einem Datenbestand von 500 Kilobyte wird mit einer Datenrate von 16 kbps übertragen. Daraus ergibt sich eine Karussellperiode von ca. vier Minuten zehn Sekunden. Bei fehlerbehaftetem Empfang und Verlust einer MSC-Datengruppe muss ohne Fehlerkorrektur die gesamte Zykluszeit abgewartet werden, bis eine erneute Aussendung derselben Daten erfolgt (falls diese nicht abermals gestört werden). Mit einer FEC-Implementierung und einem Blockinterleaver aus fünf Parallelblöcken zu 12800 Byte kann eine Rekonstruktion aber bereits nach 6,4 - 32 Sekunden (je nachdem, in welchem Pufferblock die fehlerhaften MSC Datengruppen zwischengespeichert werden) erfolgen. So können die Daten wesentlich schneller dem Nutzer dargestellt werden.

An einem weiteren Beispiel zeigt sich, dass die Puffergeometrie (Größe des Gesamtpufferspeichers und Anzahl der Pufferblöcke) durch den Rundfunkanbieter an den jeweiligen durch die FEC-Implementierung zu schützenden Datendienst angepasst werden sollte:

Ein kleiner Datendienst kann beispielsweise in 10 MSC-Datengruppen und einer Gesamtdatenmenge von 10000 Bytes bei einer Datenrate von 1000 bps übertragen. Daraus ergibt sich eine Zykluszeit von 80 Sekunden. Bei Verwendung eines 64 Kilobyte großen Interleaver-Puffers ist die maximal abzuwartende Zeit bis zur Rekonstruktion mit über 524 Sekunden länger als die Karussellperiode.

In diesem Fall wäre die Wahl eines kleineren Gesamtpufferspeichers mit wenigen Pufferblöcken sinnvoll. Um einen zeitlichen Vorteil zu erlangen, muss die Puffergröße abhängig von der Datenrate so gewählt werden, dass der Gesamtpuffer in einer kürzeren Zeit als die Karussellperiode gefüllt wird.

Bei der Wahl der Puffergeometrie ist aber zu beachten, dass eine obere Grenze für die Gesamtgröße des Pufferspeichers festgelegt werden sollte. Nur so ist es den Endgeräteherstellern möglich, einheitliche Empfänger herzustellen. Die Obergrenze wurde für die Simulation auf 64 Kilobyte festgelegt. Dadurch ergibt sich, je nach eingesetztem Fehlerschutz, eine sehr große Interleaving-Distanz (z.B. beträgt die bei der Bildung eines FEC-Codworts aus zehn Datensymbolen und einem Redundanzsymbol 6400 Byte). Zusätzlich werden auch die Anforderungen von integrierten Empfangsgeräten berücksichtigt.

Als Fehlerkorrektur-Algorithmen stehen beispielsweise Faltungscodes oder Blockcodes (auch algebraische Codes) zur Verfügung. Faltungscodes sind für eine Codierung von kontinuierlichen Datenströmen geeignet und benötigen für die Decodierung zusätzlich zu der Redundanz Informationen über vergangene Dekodierschritte. Blockcodes, die zur Fehlerkorrektur verwendet werden können, codieren hingegen die Nachricht in Blöcken und benötigen für die Decodierung lediglich die aktuelle Nachricht. Für die vorliegende Erfindung wurden insbesondere die zwei nachfolgend kurz dargestellte Blockcodes untersucht.

Die erste Möglichkeit eines Blockcodes ist die EXKLUSIV-ODER-Verknüpfung (auch XOR-Codierung genannt und im weiteren durch das Zeichen ⊕ gekennzeichnet). Diese XOR-Codierung ist eine in digitalen Systemen weit verbreitete Technik. Sie wird unter anderem bei RAID-Systemen (RAID = Redundant Array of Inexpensive/Independent Disks) zur Datensicherheit bei fehlertoleranten bzw. ausfallsicheren Systemen eingesetzt. Ein redundantes Prüfsymbol X wird aus den Nachrichtensymbolen A und B wie folgt berechnet:

$$X = A \oplus B$$

Damit gelten auch die beiden Gleichungen

$$X \oplus B = A$$

$$A \oplus X = B$$

mit denen sich bei fehlerhaftem Empfang eines Nachrichtensymbols dieses wieder herstellen lässt, wenn bekannt ist, welches der Symbole gestört ist.

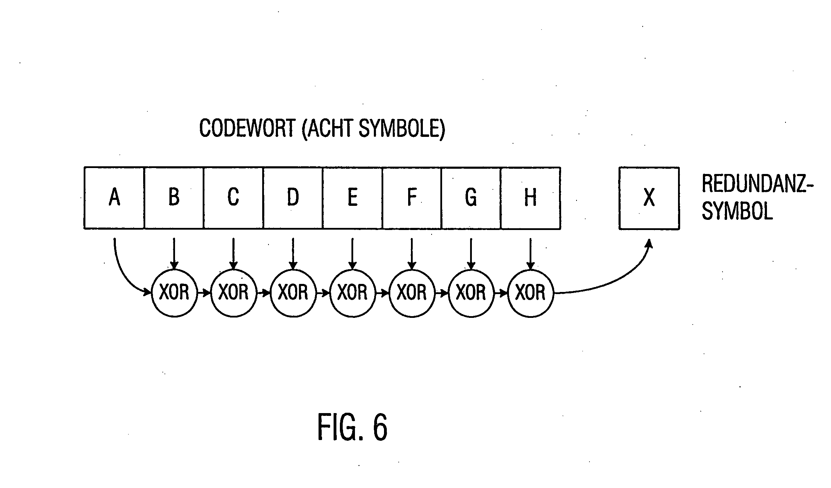

Diese Gleichungen gehalten ihre Gültigkeit auch, wenn das Redundanzsymbol X aus mehr als zwei Nachrichtensymbolen berechnet wird. Fig. 6 veranschaulicht die Bildung des Redundanzsymbols X aus acht Informationssymbolen A-H nach

$$X = A \oplus B \oplus C \oplus D \oplus E \oplus F \oplus G \oplus H$$

Mit diesem Verfahren kann ein einzelner Symbolfehler auch bei der Übertragung korrigiert werden, unabhängig von der Anzahl der Nachrichtensymbole. Damit ist eine einfache Skalierung des Overheads (Verhältnis von Redundanzsymbolen zu Nachrichtensymbolen) einfach realisierbar und kann dem jeweiligen Übertragungskanal individuell angepasst werden. Ein prinzipielles Problem der XOR-Codierung, das kaum mögliche Korrigieren von Burstfehlern, kann einfach durch Interleaving der Nachrichtensymbole behoben werden. Dadurch werden die Redundanzsymbole nicht mehr aus aufeinander folgenden Nachrichtensymbolen gewonnen, so dass bei fehlerhafter Übertragung mehrerer Symbole hintereinander jeweils nur ein Symbol pro Codewort gestört wird.

Ein großer Vorteil der XOR-Codierung ist ihre Einfachheit; alle Prozessoren können die nötigen Rechenoperationen schnell und in wenigen Taktzyklen durchführen. Damit ist XOR eine der schnellsten Fehlerschutztechniken in digitalen Systemen mit der geringsten Leistungsaufnahme.

Eine zweite Möglichkeit des Einsatzes von Blockcodes sind die Reed-Solomon-Codes. Diese Reed-Solomon-Codes werden in einer Vielzahl von Anwendungsfällen in der digitalen Kommunikation und Speicherung eingesetzt. Sie wurden entwickelt, um mehrere (auch aufeinander folgende) Symbolfehler zu korrigieren.

Hierbei bildet der Encoder aus k Datensymbolen zu je m Bit r redundante Symbole, so dass sich die Codewörter zu n=k+r Symbolen Länge ergeben. Im Gegensatz zu der XOR-Codierung kann der Decoder jedoch t fehlerhafte Symbole innerhalb eines Codewortes korrigieren, auch wenn nicht bekannt ist, welche t Symbole gestört sind.

Zur FEC-Datenübertragung ist anzumerken, dass sendeseitig die einzelnen MSC-Datengruppen in Pufferblöcke geschrieben und so zwischengespeichert werden, während sie beispielsweise gleichzeitig bereits versendet werden. Ist ein Pufferblock gefüllt, werden beispielsweise mit dem XOR-Algorithmus die für den Fehlerschutz nötigen Redundanzsymbole gebildet.

Eine Übertragung dieser für die Rekonstruktion wichtigen Redundanzsymbole und Zusatzinformationen zum Empfänger erfolgt beispielsweise in einer einzigen MSC-Datengruppe pro Pufferblock. Anhand des MSC-Datengruppen-CRCs können diese Daten dann im Decoder auf ihre Fehlerfreiheit überprüft werden.

Für eine korrekte und eindeutige Decodierung sollten dem Empfänger zwei unterschiedliche Informationsarten mitgeteilt werden. Die Adressierungsinformationen (d.h. die Versatzinformationen eines Nutzdatenblocks) beschreiben, in welchem Pufferblock und an welche Adresse innerhalb dieses Blocks die MSC-Datengruppe abgelegt wurde und enthalten allgemeine Beschreibungen des Pufferblocks. Zweitens sollten dem Empfänger die eigentlichen (redundanten) FEC-Daten übertragen werden.

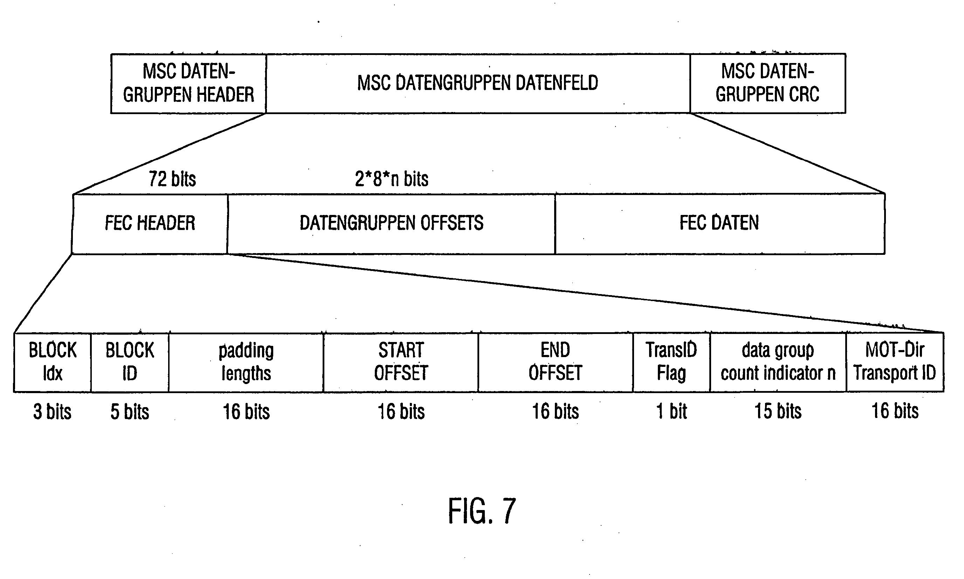

Fig. 7 zeigt den Aufbau des Datentyps, der zur Übertragung dieser Informationen entwickelt wurde. Der Header enthält allgemeine Informationen über den Pufferblock und den Inhalt der Datengruppe. Im FEC-Datengruppenbody sind die FEC-Daten und Datengruppen-Adressierungsinformationen enthalten.

Damit sind folgende Informationen in einer FEC-Datengruppe enthalten:

- BlockIdx: Dieser 3 Bit lange Parameter enthält eine fortlaufende Nummer, die fest mit einem Pufferblock (also einer BlockID verbunden ist) und jedes Mal inkrementiert wird, sobald dieser Pufferblock versendet wird. Er wird verwendet, um eine zeitliche Inkonsistenz der FEC-Daten bei Verlust einer FEC-Datengruppe zu vermeiden. Der Wert "0" stellt einen Sonderwert dar und wird beim regulären Inkrementieren übersprungen.

- BlockID: Diese 5 Bit lange eindeutige Kennnummer bezeichnet den Pufferblock, der zur Generierung dieser FEC-Datengruppe benutzt wurde.

- padding length: Dieser 16 Bit lange Parameter gibt die Länge Padding-Bereichs am Ende des Pufferblocks in Bytes an.

- start offset: Dieser 16 Bit lange Parameter im FEC-Header wird verwendet, um den Pufferblock zu beschreiben. Er enthält den Pufferblockanfang in Bytes, bezogen auf den Beginn des gesamten Pufferspeicherbereichs.

- end offset: Wie start offset, enthält aber das Ende des Pufferblocks, bezogen auf den Beginn des gesamten Puffer-Speicherbereichs. Damit gilt:

$$\texttt{start offset + Pufferblockgröße -1 = end offset}$$

- Trans-ID-Flag: Dieses Flag signalisiert, ob das MOT-Dir-Transport-ID-Feld vorhanden ist.

- data group count indicator: Diese 15 Bit lange Dualzahl enthält die Anzahl n der im Pufferblock gespeicherten und zur FEC-Datenbildung genutzten MSC-Datengruppen.

- data group offsets Field: Dieses Feld enthält n 16 Bit lange Dualzahlen, die die start offsets der einzelnen MSC-Datengruppen des Pufferblocks beschreiben. Mit ihnen kann empfangsseitig bei der FEC-Dekodierung eindeutig erkannt werden, welche MSC-Datengruppen nicht empfangen werden konnten.

- MOT-Dir-Transport-ID: Dieses 16 Bit lange Feld enthält (wenn vorhanden) die TransportID des zum Zeitpunkt der Versendung der FEC-Datengruppe gültigen MOT-Directory.

- FEC-Data-Field: Dieses Feld enthält die redundanten FEC-Daten.

In Bezug auf Zusatzinformationen der MSC-Datengruppen ist anzumerken, dass empfangsseitig erhaltene MSC-Datengruppen in den gleichen Pufferblock und dort an der gleichen Adresse abgelegt werden sollten, um mit dem inversen FEC-Algorithmus eine Rekonstruktion fehlender MSC-Datengruppen vornehmen zu können. Dafür werden zusätzliche Informationen benötigt, die mit der MSC-Datengruppe zusammen übertragen werden sollten.

Für eine genaue Adressierung des Speicherortes werden die Block-ID und der Offset der MSC-Datengruppe innerhalb des Interleaverpuffers benötigt. Um auch bei der Zwischenspeicherung der MSC-Datengruppe im Empfangspuffer eine zeitliche Inkonsistenz (Ablegen einer MSC-Datengruppe in einem veralteten Pufferblock) zu vermeiden, wird vorzugsweise zusätzlich noch der Parameter BlockIdx des Sendepuffers mit übertragen.

Diese drei Parameter lassen sich in 3 Bytes codieren. Diese können aber zum Teil meist nicht innerhalb der MSC-Datengruppe (im User-Access-Field des Headers oder innerhalb des MSC-Daetngruppen-Data-Fields) mit übertragen werden, da so der Inhalt der MSC-Datengruppe verändert würde. Damit würde empfangsseitig von der Übertragungsschicht nicht mehr dieselbe MSC-Datengruppeweitergereicht, wie sie sendeseitig eingespeist wurde. Eine Abwärtskompatibilität mit Empfängern ohne FEC-Implementierung wäre nicht mehr gewährleistet. Ein Transport der drei Parameter im User-Access-Field im MSC-Datengruppenheader ist auch aufgrund des Datendienstes NewsService Journaline® nicht möglich, da hier dieses Headerfeld nicht gesetzt sein sollte. MSC-Datengruppen mit gesetztem User-Access-Field würden von diesem Datendienst verworfen. Damit könnten existierende Empfänger bei Verwendung des Fehlerschutzes keine Nachrichten empfangen.

Die nötigen Zusatzinformationen werden neben der MSC-Datengruppe im Paddingbereich der Paketebene versendet.

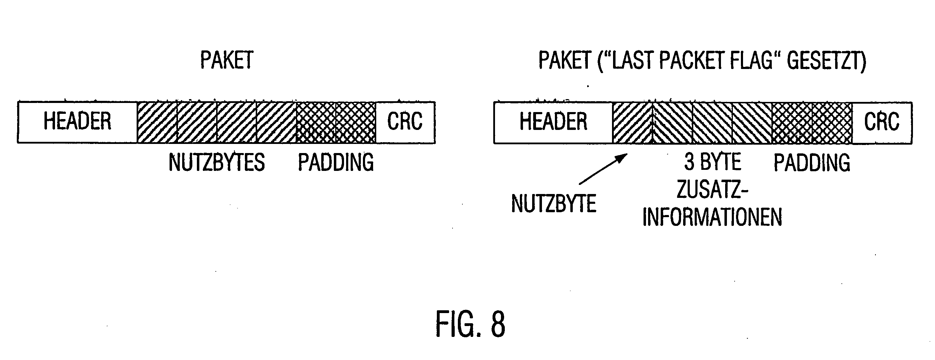

Dabei gilt es zu beachten, dass das letzte Paket einer MSC-Datengruppe mittels des "Last-Packet-Flag" speziell gesetzt ist. Ist das Padding dieses letzten Pakets für die von den Zusatzinformationen benötigten drei Bytes zu kurz, so sollten sie komplett im nächsten Paket übertragen werden. Aus Gründen der Abwärtskompatibilität ist es dann aber oftmals nötig, dass mindestens noch ein Nutzbyte in demselben Paket liegen sollte. Ältere Empfänger könnten sonst Probleme haben, wenn das letzte Paket keine Nutzdaten enthält. Der Nutzdatenanteil muss daher eventuell aufgeteilt werden, wie es in Fig. 8 exemplarisch dargestellt ist. Der MOT-Decoder kann die Position der drei Byte Zusatzinformation einfach feststellen. Sie liegen im Paket mit gesetztem "Last-Packet-Flag" direkt nach den enthaltenen Nutzdaten.

Die Standardauffüllung des Paddingbereichs sind binäre Nullen. Daher wurde der binäre Wert Null für den Parameter BlockIdx bei der Spezifizierung des FEC-Algorithmus ausgenommen. Damit können Padding-Daten eindeutig von den drei Byte Zusatzinformationen unterschieden werden. Eine binäre Null in allen drei Zusatzparametern gleichzeitig ist aufgrund der gewählten Codierung möglichst zu vermeiden.

Des weiteren kann dem Decoder ein Aussetzen des Fehlerschutzes angezeigt werden, indem alle drei Werte gleichzeitig zu Null gesetzt werden. Damit ist es beispielsweise dem Rundfunkanbieter möglich, kurzfristig und ohne spezielle Signalisierung den Fehlerschutz auszuschalten und die freiwerdende Datenrate für den Datendienst zu nutzen.

In Bezug auf eine Einordnung des FEC-Algorithmus ist anzumerken, dass bei einer Verwendung eines Interleavers die zu schützenden Daten in einem Puffer zwischengespeichert werden sollten, bevor die Fehlerschutzdaten berechnet und ausgesendet werden können. Auch empfangsseitig kann diese Zwischenspeicherung dann notwendig sein und eine Rekonstruktion verlorener MSC-Datengruppen kann nach Empfang der FEC-Daten erfolgen.

Um empfangsseitig die gleiche MSC-Datengruppenreihenfolge zu erhalten, können auch korrekt empfangene MSC-Datengruppen erst nach dem Empfang und der Anwendung der FEC-Daten und eventueller Rekonstruktion der verlorenen MSC-Datengruppen im MOT-Decoder weiterverarbeitet werden. Der Vorteil, die Reihenfolge der MSC-Datengruppen einhalten zu können, bedingt damit aber immer auch eine Latenz.

Es ist jedoch auch möglich, korrekt empfangene MSC-Datengruppen direkt nach der Zwischenspeicherung im Empfangspuffer des FEC-Decoders im MOT-Decoder weiter zu verarbeiten, ohne den Empfang der FEC-Daten und die Rekonstruktion verlorener MSC-Datengruppen abzuwarten. Da eine Rekonstruktion immer zu einem späteren Zeitpunkt erfolgt (nach dem Empfang der FEC-Daten), kann die Reihenfolge der MSC-Datengruppen daher verändert werden. Bei fehlerfreiem Empfang ergibt sich jedoch keine erhöhte Latenz.

Ob eine Veränderung der Reihenfolge von MSC-Datengruppen möglich ist, hängt von dem verwendeten Transportprotokoll und dem zu schützenden Datendienst ab.

Das Hauptaugenmerk dieser Erfindung richtet sich auf die Entwicklung einer Möglichkeit für eine Verbesserung eines Fehlerschutzes für das MOT-Protokoll, also für eine Übertragung von abgeschlossenen Dateneinheiten, die beispielsweise in einem Datenkarussell periodisch ausgesendet werden. Bei der Übertragung von Datendiensten, die in einem solchen Karussell versendet werden, spielt die Reihenfolge, in der die empfangenen MSC-Datengruppen verarbeitet werden, eine untergeordnete Rolle. Der erfindungsgemäße Ansatz bietet jedoch den Vorteil, eine Möglichkeit zu schaffen, dass im fehlerfreien Fall keine Erhöhung der Latenz eintritt, aber im Fehlerfall durch die Fehlerkorrektur ein deutlicher Zeitgewinn gegenüber dem Warten auf die nächste Aussendung erzielt werden kann.

Der Einsatz eines Fehlerschutzverfahrens ist aber nicht nur sinnvoll, um die nötige Empfangszeit zu verkürzen. Bei gestörtem Empfang kann es durch ihn überhaupt erst möglich werden, einen Datendienst akzeptabel nutzen zu können.

Um den in diesem Ausführungsbeispiel beschriebenen Fehlerkorrekturmechanismus, bestehend aus einem erweiterten Blockinterleaver und einer XOR-Codierung für einen Schutz des MOT-Protokolls nutzen zu können, ist jedoch das Einfügen zusätzlicher Informationen in die Aussendung der FEC-Daten nötig, um eine empfangsseitig konsistente Decodierung zu ermöglichen.

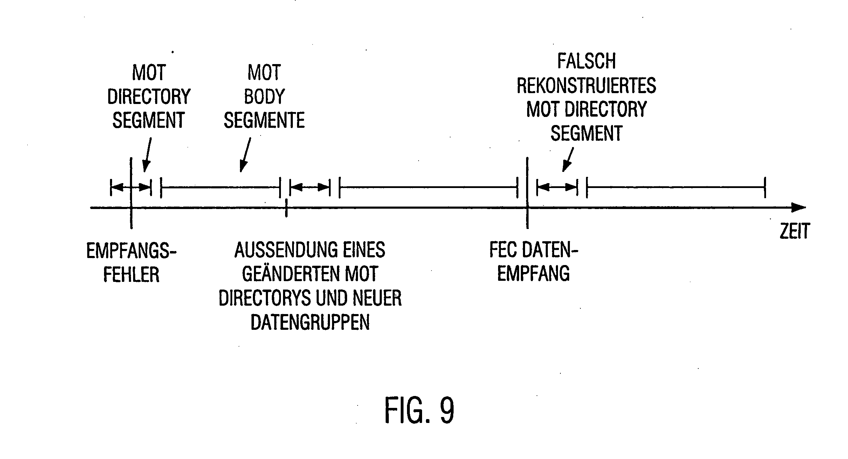

Bei der Übertragung im MOT-Directory-Mode muss die Gültigkeit des "MOT-Directory" beachtet werden, das die Verwaltungsinformationen der aktuell versendeten MOT-Objekte enthält. Hierbei ist jedoch die Latenz zu beachten, die sich unter Umständen aus der Rekonstruktion eines MOT-Directory-Segments nach der Durchführung des FEC-Algorithmus ergibt. Zum Rekonstruktionszeitpunkts sollten die enthaltenen Verwaltungsinformationen nicht mehr gültig sein, wie es in Fig. 9 dargestellt ist. Ein neues MOT-Directory, das geänderte Verwaltungsinformationen enthält, kann in der Zwischenzeit erfolgreich übertragen worden sein. Würde nun ein Segment eines alten MOT-Directorys rekonstruiert, dann würde der Decoder annehmen, dass das zuletzt empfangene MOT-Directory nicht mehr gültig ist. Um diese Inkonsistenz zu vermeiden, muss gleichzeitig mit den redundanten FEC-Informationen, also zusammen mit der FEC-Datengruppe, auch eine eindeutige Identifikation des zu diesem Zeitpunkt gültigen MOT-Directory mit versendet werden, die empfangsseitig eine Erkennung veralteter Versionen erlaubt. Hierfür kann der MSC-Datengruppenparameter TransportID genutzt werden. Dieser 16 Bit lange Parameter identifiziert eindeutig ein Datenobjekt (MOT-Body, MOT-Directory und MOT-Header) während seiner Übertragung. Rekostruierte MOT-Directory-Segmente werden nur dann an den MOT-Decoder weitergereicht, wenn ihre TransportID diesem Parameter entspricht.

Auch ist bei Verwendung des MOT-Header-Mode eine Rekonstruktion veralteter MOT-Einheiten zu verhindern, da in diesem Mode immer nur ein MOT-Objekt zu einem Zeitpunkt gültig ist. In diesem Mode ist zu beachten, dass das aktuelle Objekt evtl. mehrfach direkt hintereinander wiederholt wird. Daher muss von Fall zu Fall entschieden werden, ob der Einsatz eines Fehlerschutzes sinnvoll ist. Eventuell erhöht eine Wiederholung die Fehlerresistenz oder verringert den Overhead im Vergleich zu einer FEC-Datenübertragung. Wenn FEC eingesetzt wird, können z.B. die FEC-Daten schon versendet werden, obwohl der FEC-Puffer noch nicht vollständig gefüllt ist.

Zusammenfassend ist anzumerken, dass durch die vorliegende Erfindung eine Möglichkeit geschaffen wird, einen abwärtskompatiblen Fehlerschutz, beispielsweise auf Datengruppenebene für digitale Rundfunksysteme wie DAB und DRM bereitzustellen, der auch für andere Daten blockorientierte Übertragungen (z.B. das Internetprotokoll) anwendbar ist, bei denen ganze Blöcke vollständig korrekt empfangen oder komplett verworfen werden. Die Originalinformationen werden vorzugsweise durch den FEC nicht verändert. Der FEC arbeitet dabei vorzugsweise auf MSC-Datengruppenebene und kann alle Datendienste schützen, die Datengruppen nutzen, also Blöcke von Daten, die entweder vollständig korrekt empfangen oder komplett verworfen werden. Der Fehlerschutz lässt sich abwärtskompatibel ausgestalten, d.h. existierende Empfänger können einen mit diesem FEC-Verfahren geschützten Datendienst decodieren wie bisher auch schon. Diese Empfänger werden die FEC-Daten ignorieren; sie können daher auch nicht vom verbesserten Fehlerschutz profitieren. Neuere Empfänger können die FEC-Daten beispielsweise erkennen und auswerten und vom verbesserten Fehlerschutz profitieren.

Der Fehlerschutz auf Datengruppenebene umfasst vorzugsweise alle Datendienste, die die Übertragungsprotokolle MOT (Multimedia-Object-Transfer), IP (Insertion) TDC (Transparent-Data-Channel im Datengruppenmodus) oder proprietäre Protokolle nutzen (wie es z.B. Jounaline ® macht).

Die meisten Datendienste in DAB (Digital-Audio-Broadcasting) und DRM (Digital-Radio-Mondial) nutzen Datengruppen und können daher von diesem zusätzlichen Schutz profitieren.

Der Fehlerschutz schützt vorzugsweise einzelne Datendienste. Üblicherweise können in DAB/DRM mehrere Datendienste in einem Kanal übertragen werden. Der Fehlerschutz kann individuell für einzelne Datendienste aktiviert und parametrisiert werden.

Gemäß einem Ausführungsbeispiel der vorliegenden Erfindung nutzt das Verfahren einen speziellen Datengruppentyp, um die FEC-Daten von den zu schützenden Daten zu unterscheiden.

"klassische" FEC-Verfahren schützen jeweils eine feste, vorab festgelegte Anzahl von Bytes. Sendeseitig wird zu dieser Anzahl Byte die FEC-Information bestimmt und zusätzlich zu den Daten mitgeschickt. Um "Burst-Errors" (d.h. lange Sequenzen von Fehlern) beheben zu können, werden die Daten vor der FEC-Codierung fast immer durch einen Interleaver umsortiert, d.h. Daten, die im Originaldatenstrom benachbart sind, sind nach dem Interleaver nicht mehr benachbart. Der Fehlerschutz muss daher keine langen Fehlersequenzen korrigieren können, sondern viele kurze Fehlersequenzen. Die Anzahl der Fehler ändert sich durch den Interleaver nicht, aber es ist technisch einfacher, viele Einzelfehler zu korrigieren als lange Burstfehler.

Ein zusätzlich hinzugefügter Interleaver führt aber dazu, dass die Nutzdaten den Interleaver typischerweise in anderer Reihenfolge verlassen.

Für die Abwärtskompatibilität ist es besonders günstig, dass die Nutzdaten jedes Datenblocks exakt in derselben Reihenfolge empfangsseitig verarbeitet werden können, wie ohne FEC (speziell eben ohne den Interleaver, der die Nutzdaten umsortiert). Daher wird bei dem vorstehend beschriebenen Ansatz vorzugsweise ein "virtueller" Interleaver eingesetzt, bei dem zwar die Nutzdaten für die Bestimmung der FEC-Daten "virtuell" umsortiert werden; die Nutzdaten aber dennoch in ihrer Originalreihenfolge übertragen werden. Auf Empfangsseite werden die Daten vorzugsweise ebenfalls "virtuell" umsortiert, bevor die FEC-Daten als Fehlerschutz angewendet werden. Eventuell korrigierte Daten werden dann entsprechend wieder umsortiert, bevor sie an die weiteren Verarbeitungsstufen auf Empfangsseite weitergegeben werden. Die Umsortierungen erhöhen zwar den Aufwand, stellen aber die Abwärtskompatibilität sicher.

Bei dem vorgeschlagenen Ansatz kann insbesondere ein Blockinterleaver in einer Matrix- oder Rechteckform betrachtet werden. Die Nutzdaten werden vorzugsweise zeilenweise eingetragen (beginnend in der "oberen linken Ecke": zuerst die erste Zeile lang. Ist diese vollkommen gefüllt, dann wird mit dem Eintragen in der nächsten Zeile begonnen und dieses Verfahren wird bis zur "unteren rechten Ecke" fortgesetzt. Eingetragen werden vorzugsweise nur Datengruppen, die noch komplett in den Block passen. Ist der Block voll (eine Datengruppe sollte eingefügt werden, passt aber nicht mehr komplett in den Block), dann werden spaltenweise die Fehlerkorrekturdaten (die FEC-Korrekturdaten) bestimmt und übertragen und der Blockinterleaver geleert. Die neue Datengruppe, die das Berechnen der FEC-Daten angestoßen hat, wird anschließend in den nunmehr leeren Block eingetragen (wieder starten in der linken oberen Ecke).

Der vorstehend beschriebene Ansatz nutzt vorzugsweise einen "virtuellen Interleaver", wie er vorstehend beschrieben wurde, damit die Nutzdaten in unveränderter Reihenfolge übertragen werden können.

Im vorstehend beschriebenen Ansatz werden vorzugsweise so lange Daten zu einem Interleaverblock hinzugefügt, bis dieser die nächste Datengruppe nicht mehr aufnehmen kann. Der Rest des Interleaverblocks wird dabei für die Bestimmung der FEC-Daten mit Nullen gefüllt. Diese Nullen werden vorzugsweise nicht übertragen, aber dem FEC-Decoder wird die Länge dieses Nullen-Bereichs mitgeteilt. Auf diese Weise ist der komplette Inhalt des Interleaverblocks dem FEC-Decoder für die FEC-Decodierung bekannt, auch wenn die Nullen selbst nicht übertragen werden.

Der in der vorliegenden Erfindung vorgeschlagene Ansatz markiert vorzugsweise alle Datengruppen so, dass sie beispielsweise in einem virtuellen Interleaver an der richtigen Stelle einsortiert werden können, egal wie viele Datengruppen vorher verloren wurden.

Diese Markierung erfolgt im Padding-Bereich einer Schicht unterhalb der Datengruppenschicht (also auf Paketebene). Existierende Empfänger werden diese Daten meist ignorieren, da die vorgeschlagene Codierung vorzugsweise so gewählt ist, dass sie im Padding-Bereich liegt, der normalerweise von den Empfängern ignoriert wird.

Vorzugsweise werden bei der FEC-Decodierung nur Datengruppen berücksichtigt, die diese zusätzlichen Versatzinformationen tragen. Es ist daher dynamisch möglich, einzelne Datengruppen vom FEC-Schutz auszunehmen, z.B. weil sie zu groß für die gewählte FEC-Parametrisierung sind.

Der "virtuelle" Interleaver erlaubt somit vorzugsweise die Verwendung eines einzelnen Interleaverblocks (d.h. alle Datengruppen werden in diesen Interleaverblock eingetragen) oder auch die Verwendung mehrerer Interleaverblöcke, in die Daten reihum geschrieben werden. D.h. anstelle eines großen FEC-Blocks kann es in eiligen Fällen mehrere kleinere geben. Dies erlaubt, die Größe und Anzahl der FEC-Datenblöcke (die ja als eine oder mehrere Datengruppen übertragen werden sollten), parametrisieren zu können. Die Entscheidung, welche Datengruppe in welchen Block einsortiert wird, trifft vorzugsweise die FEC-Codierseite und sie teilt dies beispielsweise in den Verwaltungsinformationen mit, die an jede Datengruppe der Nutzdaten angefügt werden.

Genauso wie die Nutzdaten enthalten vorzugsweise auch die FEC-Daten zusätzliche Verwaltungsinformationen, um genau bestimmen zu können, wie viele Datengruppen welcher Länge wo im virtuellen Interleaver hätten einsortiert werden sollen. Auf diese Art und Weise ist dann beispielsweise dem FEC-System bekannt, welche Datengruppe welcher Länge fehlen und es kann bestimmt werden, ob und gegebenenfalls wie diese Daten zu rekonstruieren sind.

Die FEC-Daten eines Interleaverblocks können vorzugsweise in einer oder mehreren speziell gekennzeichneten Datengruppen übertragen werden. Vom Overhead her ist es beispielsweise am günstigsten, wenn man mit einer Datengruppe pro FEC-Block auskommt.

Wie bereits erwähnt wurde, können ein oder mehrere Interleaverblöcke verwendet werden. Es wird empfohlen, so viele Interleaverblöcke zu verwenden, dass die für die Korrektur dieser Daten generierten FEC-Informationen noch in eine einzige Datengruppe passen. Die Datengruppe bei DAB/DRM erlauben eine maximale Länge von 8191 Bytes netto. Da die Wahrscheinlichkeit von Empfangsfehlern innerhalb einer Datengruppe (ein Empfangsfehler führt dazu, dass die komplette Datengruppe verloren ist) von der Größe der Datengruppe abhängt, ist es sinnvoll, deutlich kleinere Datengruppen zu verwenden. Der hier vorgeschlagene Ansatz erlaubt die Parametrisierung der Datengruppengröße der FEC-Daten.

Die Daten innerhalb eines Interleaver-Blocks werden bisher mit XOR geschützt. Dies erlaubt, einen Fehler pro Interleaver-Spalte zu korrigieren. Je nach Bufferanzahl und - größe können das eine oder mehrere (komplett verlorengegangene) Datengruppen sein. Wichtig ist, dass jede Datengruppe vorzugsweise nicht länger als eine Zeile des Interleaver-Blocks sein sollte, da ansonsten eine fehlende Datengruppe zwei oder mehrere Fehler in einer Spalte hervorruft.

XOR scheint dabei ein guter Kompromiss zwischen Fehlerschutz und Overhead (sowohl was die Datenrate für die FEC Daten anbelangt als auch die Komplexität der Berechnung) zu sein.

In der vorliegenden Erfindung wurde daher vertieft auf den XOR Fehlerschutz eingegangen (welcher einen Fehler pro Spalte unseres Interleaver-Blocks korrigieren kann). Andere Fehlerschutzverfahren (Reed Solomon etc.) sind auch nutzbar. Vorzugsweise sollte nur bei Sender und Empfänger eine entsprechende Einfügung der Datensätze in den Speicher erfolgen, d.h. dass beispielsweise die Ausleserichtung in Sender und Empfänger jeweils spaltenweise ist (von links oben die erste Spalte nach unten, dann die zweite Spalte usw.).

Wie bereits oben erwähnt, "sammeln" "klassische" Interleaver üblicherweise Nutzdaten, berechnen dann die FEC Informationen und geben die Daten erst weiter, nachdem der komplette Block inklusive der FEC Daten verfügbar ist. Das bedeutet, dass das "klassische" Interleaving die Daten immer verzögert.

Empfangsseitig kann diese "klassische" Vorgehensweise wie folgt exemplarisch beschrieben werden: Zuerst werden alle korrekt empfangenen Nutzdaten in den jeweiligen Interleaver-Block eingetragen. Sobald die FEC Daten für den entsprechenden Interleaver-Block vollständig empfangen sind, werden eventuell fehlende/ verfälschte Daten rekonstruiert. Die Daten eines Interleaver-Blocks werden aber erst dann weitergereicht, nachdem ALLE Daten empfangen wurden. Auch empfängerseitig werden die Daten also immer verzögert.

Der Grund dafür, dass beim "klassischen" Interleaver gewartet werden muss, bis der Interleaver-Block gefüllt ist, liegt darin, dass durch das Interleaving die Daten umsortiert werden, also Teile der Daten, die zum Schluss in den Block einzutragen sind, auch an den Beginn des Block sortiert werden. Von daher können die Daten eines Blocks noch nicht weitergereicht werden, bis alle Daten vorhanden und alle "Lücken" in den Daten geschlossen sind.

In vorstehend beschriebenen Ansatz kann diesbezüglich aber einen "virtuellen" Interleaver eingesetzt werden. Das heißt dass die Nutzdaten unverändert übertragen werden. Aus diesem Grund können sie sendeseitig auch ohne Verzögerung versendet werden und gleichzeitig eine Kopie in einem Interleaver-Block abgelegt werden. Ist der Interleaver-Block gefüllt, dann werden die FEC Daten generiert und abgeschickt. Es tritt also aufgrund des "virtuellen" Interleavers keine Verzögerung der Daten auf.

Empfangsseitig muss man zwei Fälle unterscheiden. Es gibt Anwendungen, die die Nutzdaten in genau der Reihenfolge benötigen, in der sie auch generiert wurden (ein Video beispielsweise oder andere Streaming- Anwendungen). Solche Anwendungen erfordern wie beim "klassischen" Interleaver eine Verzögerung; nämlich um die Zeit, die es dauert, die (alle!) FEC-Blöcke zu füllen und die verlorengegangenen Datengruppen zu rekonstruieren. Erst nachdem alle FEC Daten angewandt und alle Blöcke bearbeitet wurden, ist bekannt, welche Datengruppen wieder hergestellt werden konnten und welche unwiederbringlich verloren sind.

Andere Anwendungen nutzen die zyklische Übertragung von Daten (z.B. von Dateien). D.h. die Daten werden in kleine Datenblöcke unterteilt und versendet. Jeder Datenblock enthält Informationen darüber, zu welcher "Datei" er gehört und welchen Teil der "Datei" er enthält. Ein Protokoll, der eine derartige zyklische Übertragung vorsieht, ist das MOT Protokoll, das in DAB und DRM für die Übertragung von Multimediadaten genutzt wird.

Bei solchen Protokollen ist die Reihenfolge unerheblich, in der die Daten empfangen werden. Eine Anwendung, deren Daten einmal pro Viertelstunde übertragen werden, kann natürlich stark davon profitieren, wenn verlorengegangene Datengruppen beispielsweise nach einer Minute (nachdem der entsprechene Interleaver-Block gefüllt ist und die FEC Daten empfangen wurden) wieder hergestellt werden können und nicht die erneute Aussendung der Daten eine Viertelstunde später abgewartet werden muss.

Die Verzögerung auf Sendeseite ist für den Nutzer von Datendiensten unerheblich (es spielt keine Rolle, ob die Daten vor 2 Sekunden oder vor 25 Sekunden generiert wurden). Empfangsseitig macht es beim Einschalten des Geräts aber einen großen Unterschied, ob die ersten Daten nach 10 Sekunden angezeigt werden können oder erst nach einer Minute.

Die Latenz hängt von der Größe des Interleavers ab. Je kleiner der Speicher (d.h. der Interleaver) ist, desto geringer ist die Latenz (und desto billiger natürlich auch das Empfangsgerät). Die Größe des Interleavers bestimmt allerdings auch, wie viele verlorengegangene Datengruppen rekonstruiert werden. Datengruppen sind üblicherweise einige Kilobytes groß (beispielsweise maximal ca. 8KB), und es wird ein Interleaver benötigt, der mehrere Datengruppen gleichzeitig aufnehmen kann. Der vorstehend beschriebene Ansatz basiert auf einer Empfehlung für eine maximale Größe des Interleavers von 64KB. Entsprechend der Datenrate des Dienstes kann es einige Sekunden bis Minuten dauern, bis ein Interleaver-Block vollständig gefüllt ist (bei 4000 Bits pro Sekunde beispielsweise ca. 2 Minuten).

Bei Anwendungen mit zyklischer Versendung der Daten bietet das "virtuelle" Interleaving daher die Möglichkeit, die Nutzdaten nicht zu verzögern, und dennoch verlorengegangene Nutzdaten mit akzeptablen Verzögerungszeiten rekonstruieren und nutzen zu können.

Das MOT Protokoll beschreibt alle zu einem Zeitpunkt versendeten Daten mit speziellen Verwaltungsinformationen (dem sogenannten MOT Directory). Auch diese Verwaltungsinformationen werden in Datengruppen aufgeteilt und versendet. Es sollte sichergestellt sein, dass im Falle einer Änderung dieser Verwaltungsinformationen (also wenn Dateien geändert, hinzugenommen oder entfernt werden) eine eventuell verlorengegangene und später rekonstruierte Datengruppe dieser Verwaltungsinformationen nicht an den MOT Dekoder weitergereicht wird. Der Fehlerschutz sollte also erlauben, veraltete Verwaltungsinformationen zu erkennen und deren Rekonstruktion und Weitergabe zu verhindern.

Der in vorstehend beschriebene Ansatz enthält vorzugsweise bei den FEC Daten auch die Information darüber, welche Version der Verwaltungsdaten gerade gültig ist (diese Information ist die TransportId, also die Transport-Kennung, die alle Datengruppen einer bestimmten Version der Verwaltungsdaten markiert). Auf diese Weise kann sichergestellt werden, dass keine veralteten Verwaltungsdaten weitergegeben werden. Durch diese Informationen funktioniert der Fehlerschutz auch dann besonders gut, wenn die versendeten Daten regelmäßig aktualisiert werden.

Vorzugsweise bezieht sich die vorliegende Erfindung auf die Verwendung eines speziellen Datengruppentyps bei DAB und DRM, der die FEC Daten überträgt. Die FEC Daten können jeweils in einer oder mehreren Datengruppen übertragen werden.

Die Verwendung eines "virtuellen" Blockinterleavers (Zeilenweises Einfügen, spaltenweise Fehlerkorrektur), der abwärtskompatiblen Fehlerschutz erlaubt begünstigt eine geringe Latenz des Interleavers. Vorstellbar wären natürlich auch "klassische" Interleaver, auch wenn damit keine Abwärtskompatibilität und eine erhöhte Latenz "erkauft" werden würde. Für Streaming-Anwendungen (wie Video) ist die erhöhte Latenz auf Empfangsseite aber ohnehin unvermeidbar, da rekonstruierte Datengruppen nur dann genutzt werden können, wenn die Reihenfolge der Datengruppen nicht verändert wird. Die weiteren folgenden Aspekte sind unabhängig davon, welcher Interleaver genutzt wird.

Der Fehlerschutz (zumindest der mit dem "virtuellen" Interleaver) fügt vorzugsweise im fehlerfreien Fall keine Latenz bei der Verarbeitung der empfangenen Daten ein. Im Fehlerfall können rekonstruierte Daten eventuell in anderer Reihenfolge verarbeitet werden als im fehlerfreien Fall. Für viele Übertragungsprotokolle ist das jedoch kein Problem.

Der Interleaver kann einen oder mehrere Blöcke verwalten. Die Geometrie der Blöcke ist flexibel und kann zur Laufzeit geändert werden (da signalisiert).

Die Aufteilung der Nutz- Datengruppen auf die einzelnen Blöcke kann flexibel und dynamisch veränderbar sein.

Einzelne Datengruppen können durch die Signalisierung auch kurz- oder längerfristig vom FEC ausgenommen werden (z.B. wenn einzelen Datengruppen zu groß sind oder kurzzeitig keine Datenrate für den Fehlerschutz zur Verfügung steht). Zusatzinformationen für den Fehlerschutz werden im Padding-Bereich der darunterliegenden Transportschicht (z.B. beim Packet mode) im Padding-Bereich der Pakete übertragen (z.B. wäre am sinnvollsten im letzten Packet am Ende der Datengruppe; denkbar ist auch der Einsatz im PAD Kanal von DAB) Dies erlaubt das Eintragen der Nutzdaten in den jeweiligen FEC Block. (Siehe auch unten, wie die Zusatzinformationen bei IP (IP = Internet Protocol) basierten Anwendungen übertragen werden können). Diese Zusatzinformationen könnten auch innerhalb der Nutzdaten (also innerhalb der Datengruppen) übertragen werden, z.B. im "end user address field".

Bei Übertragungsverfahren, die keine Möglichkeit vorsehen, diese Zusatzinformationen an die einzelnen Übertragungsblöcke anzufügen, die einzelnen Datenblöcke aber eine eindeutige Kennung haben (z.B. Objektkennung / Segmentnummer; eindeutige Sequenznummer; ...) kann diese Information auch zusätzlich übertragen werden (beispielsweise als Teil der FEC Informationen). Da aber in diesem Fall die Information, wo ein Block im Interleaver einzutragen ist, eventuell erst später verfügbar ist, kann dabei der Speicherbedarf höher sein (die Datenblöcke müssen zwischengespeichert werden und können erst nach Empfang dieser FEC Informationen in den Interleaver eingetragen werden, weil erst dann deren Position im Interleaver bekannt ist).

Die FEC Daten (als eigene Datengruppe/n) enthalten vorzugsweise die Fehlerkorrektur-Daten, um verlorengegangene Daten rekonstruieren zu können (auch mehrere hintereinander verlorene Datengruppen), inklusive der Daten, die angeben, welche verlorenen Datengruppen wo im Interleaver-Block hätten eingetragen werden müssen (falls sie empfangen worden wären).

Die Fehlerkorrektur nutzt beispielsweise XOR, andere Verfahren wie Reed-Solomon etc. könnten auch eingesetzt werden.

Die Fehlerkorrektur gibt beispielsweise die TransportId des zum Zeitpunkt der FEC Daten-Generierung gültigen MOT Directories an. Dies stellt sicher, dass der Empfänger alte Verwaltungsinformationen des MOT Protokolls erkennen und ignorieren kann. Andere Transportprotokolle können eventuell andere Kennzeichnungen für die aktuelle Version der Verwaltungsdaten nutzen. Wichtig ist lediglich, dass das Prinzip der Kennzeichnung auch für andere Protokolle angewandt werden kann.

Der Fehlerschutz ist auch auf IP anwendbar. In diesem Fall würde man nicht den Begriff "Datengruppe" verwenden, sondern von "UDP Datagrammen" sprechen. Der Schutz wäre beispielsweise denkbar für Anwendungsfälle, in denen die Daten "über Luft" (z.B. per IP Multicast/IP Broadcast) versendet werden (beispielsweise Satellit, UMTS, GPRS, WLAN, oder DAB/DRM per IP Tunnelling etc.) und auch zyklisch versendete Daten umfassen (also ein Datenkarusell-Streaming). Bei Medien wie Glasfaser oder Kabel wäre es auch einsetzbar.

Bei reinen Internet Punkt-zu-Punkt Anwendungen (wie Email, HTTP usw.) ist der Fehlerschutz dagegen zumeist nicht nötig, da hierfür TCP/IP genügend Schutz bietet. Wenn aber eine Quelle viele Anwender zyklisch mit Daten versorgt (z.B. ein News-Ticker), dann kann der Schutz sinnvoll sein.

Der vorstehend beschriebene Ansatz gilt auch für alle Übertragungssysteme, die IP als Transportschicht anbieten (DVB, Sky-DSL etc.).

Die Zusatzinformationen, die vorzugsweise an die Nutzdaten angefügt werden (und beispielsweise angeben, in welcher Position in welchem Block die Daten einzutragen sind), könnte bei IP im IP Header abgelegt werden.

Der vorgeschlagene Ansatz ist auch anwendbar für andere datenblockorientierte Übertragungen, bei denen ganze Blöcke vollständig korrekt empfangen oder komplett verworfen werden. Die Original-Informationen werden durch den FEC nicht verändert (zumindest bei Einsatz des "virtuellen" Interleavers).

Das Verfahren funktioniert weiterhin mit jedem beliebigen Fehlerschutz.

Für eine abwärtskompatible Versendung sollten aber die Originaldaten für die Bestimmung des Fehlerschutzes nicht allzu sehr verändert werden. Die Daten können zwar für die Fehlerschutzberechnung temporär umsortiert (Interleaving) werden; damit aber die Datenblöcke im Übertragungskanal völlig unverändert übertragen werden können, sollte das Fehlerschutzverfahren die Originaldaten nur so weit verändern, dass diese Veränderungen von der Empfangsseite mit den empfangenen Original-Daten "nachgebildet" werden können, bevor der Fehlerschutz empfangsseitig angewandt wird.

Im einfachsten Fall verändert der Fehlerschutz die Reihenfolge der Daten nicht, die er schützt. Die Sendeseite lässt dann über die Kopie der versendeten Datenblöcke die FEC Daten bestimmen; die Empfangsseite rekonstruiert die verlorengegangenen Datenblöcke.

Nutzt das Fehlerschutz ein Interleaving und nimmt an, dass die Daten so übertragen werden, wie sie nach der Umsortierung von Fehlerschutz zur Verfügung gestellt werden, dann sollte das Folgende gemacht werden:

Sind die Daten nur durch einen Interleaver geschickt worden (also nur umsortiert worden), dann sollte empfangsseitig vor dem Anwenden der Fehlerschutzes derselbe Zustand des Interleaverpuffers hergestellt werden, der sendeseitig auch bestand. Das heißt beim Interleaver werden sendeseitig zuerst die Daten umsortiert, und danach der Fehlerschutz bestimmt. Werden die Daten in anderer Reihenfolge übertragen als von diesem Fehlerschutz-Interleaver gedacht, dann müssen empfangsseitig zuerst die Daten (die ja in ihrer Originalreihenfolge und Aufbau übertragen werden) in einen Zwischenpuffer eingetragen werden; aber bevor der Fehlerschutz angewandt werden kann, sollte erst einmal das auf Sendeseite verwendete Interleaving wiederholt werden, damit der Fehlerschutz für die folgende Fehlerkorrektur die Daten in der Reihenfolge vorfindet, in der er sendeseitig den Fehlerschutz bestimmt hat.

Das heißt empfangsseitig sollte dann zweimal ein Interleaver benutzt werden. Erst zum Rekonstruieren des Interleaverpuffers auf Sendeseite, dann wieder "zurück"- interleaven, um die rekonstruierten Daten wieder in ihrer Originalreihenfolge zu erhalten. Gegebenenfalls können während des "Zurück-Interleavens" nach der Fehlerkorrektur aber auch nur die ursprünglich fehlenden/ defekten Daten direkt extrahiert worden, so dass kein zweiter vollständiger Interleaver- Puffer nötig ist.

Somit ergeben sich also drei Aspekte:

a) Bei dem vorstehend beschriebenen Ansatz (oder das Fehlerschutzverfahren), bei dem die Daten vorzugsweise in einem Kanal variabler Datenrate übertragen werden, werden die Datenblöcke und FEC Daten so markiert, dass ein FEC angewandt werden kann. Der Ansatz erlaubt verschiedene Fehlerschutzverfahren, verschiedene Interleaver sowie verschiedene Puffergrößen und -anzahl. Falls "Virtuelles Interleaving" eingesetzt wird, kann eine abwärtskompatible Versendung möglich sein. Das "virtuelle Interleaving" führt zu keiner Erhöhung der Latenz auf Sendeseite. Das Markieren der Daten hängt vom Übertragungsprotokoll ab.

b) Der vorstehend beschriebene Ansatz bietet eine Möglichkeit, in DAB und DRM durch geschicktes Markieren der Datenblöcke sowie der FEC Daten und durch "virtuelles Inter-leaving' eine abwärtskompatible Versendung durchführen zu können. Das "virtuelle Interleaving" führt zu keiner Erhöhung der Latenz auf Sendeseite. Das Markieren der Daten hängt vom Übertragungsprotokoll ab; vorstehend sind dabei insbesondere DAB und DRM erwähnt.
Das Markieren bei den Datenblöcken erfolgt dabei im Padding-Bereich auf Packet-Ebene bzw. "PAD sub field"-Ebene. Möglich wäre auch eine Markierung der Daten im End User Address Field der Datengruppen. Das Markieren der Originaldatenblöcke (des abwärtskompatible Hinzufügen von Zusatzinformationen) könnte auch für andere Zusatzinformationen genutzt werden.

c) Der vorstehend beschriebene Ansatz bietet ferner eine Möglichkeit, durch Signalisierung des Versionsstandes von Verwaltungsinformationen sicherzustellen, dass der Empfänger die korrekt empfangenen Daten sofort weiterverarbeiten kann und die später (nach Empfang der FEC Daten) korrigierten Datenblöcke vorzugsweise nur dann weiterverarbeitet werden, wenn sie nicht bereits veraltet (und damit "schädlich") sind. Die vorgeschlagene Möglichkeit, wie die Signalisierung des Versionsstandes der Verwaltungsinformationen erfolgt, hängt jeweils vom verwendeten Übertragungsprotokoll ab; unsere Lösung bezieht sich auf das MOT Protokoll für DAB und DAM.

Abhängig von den Gegebenheiten kann das erfindungsgemäße Verfahren zum Senden von Informationsdaten oder zum Empfangen von Informationsdaten in Hardware oder in Software implementiert werden. Die Implementierung kann auf einem digitalen Speichermedium, insbesondere einer Diskette oder CD mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit einem auf einem maschinenlesbaren Träger gespeicherten Programmcode zur Durchführung des erfindungsgemäßen Verfahrens, wenn das Computerprogrammprodukt auf einem Rechner abläuft. Mit anderen Worten ausgedrückt, kann die Erfindung somit als ein Computerprogramm mit einem Programmcode zur Durchführung des Verfahrens realisiert werden, wenn das Computerprogramm auf einem Computer abläuft.

**Patentansprüche**

1. Sender (100) zum Senden von Informationsdaten, die in einer Mehrzahl von Datensätzen unterschiedlicher Größe vorliegen, mit folgenden Merkmalen:

einer Einrichtung zum Ermitteln von Fehlerkorrekturdaten zur Korrektur eines Übertragungsfehlers in einem der Mehrzahl der Datensätze, wobei die Einrichtung zum Ermitteln ausgebildet ist, die Informationsdaten umzusortieren, indem die Informationsdaten von aufeinanderfolgenden Datensätzen reihum zeilenweise in eine Mehrzahl von Pufferblöcken geschrieben werden, wobei eine oder mehrere aufeinanderfolgende Datensätze so lange zeilenweise in denselben Pufferblock geschrieben werden, dass eine Gesamtlänge einer Pufferblockzeile nicht überschritten wird,
wobei die Informationsdaten eines Datensatzes in nicht mehr als einen Pufferblock geschrieben werden, wobei Datensätze, die länger als eine Pufferblockzeile sind, nicht in die Pufferblöcke eingetragen werden und damit die erreichte Interleaving-Distanz den Wert von Pufferblockzeilenlänge mal Pufferblockanzahl hat,
wobei die Einrichtung zum Ermitteln ferner ausgebildet ist um aus den Informationsdaten der einzelnen Pufferblöcke getrennt die Fehlerkorrekturdaten spaltenweise zu ermitteln;
einer Einrichtung (102) zum Zuweisen einer Versatzinformation zu einem oder mehreren Datensätzen der Mehrzahl von Datensätzen, wobei die Versatzinformation angibt, in welchem Pufferblock und an welcher Adresse innerhalb dieses Pufferblockes ein entsprechender Datensatz eingeschrieben wurde ;

einer Einrichtung zum Senden der Mehrzahl von Datensätzen und der den entsprechenden Datensätzen zugeordneten Versatzinformation, wobei die Einrichtung (104) zum Senden ausgebildet ist, um die Informationsdaten nicht-umsortiert zu übertragen und die Datensätze in Datenpakete einer Transportschicht einzubetten, wobei die Einrichtung (104) zum Senden ferner ausgebildet ist, um die einem Datensatz zugeordnete Versatzinformation in einem Padding-Bereich der Datenpakete der Transportschicht zu integrieren; und
einer Einrichtung zum Aussenden der Fehlerkorrekturdaten.

2. Sender (100) Anspruch 1, bei dem die Einrichtung zum Ermitteln ausgebildet ist, um die Fehlerkorrekturdaten auf der Basis einer EXKLUSIV-ODER-Verknüpfung zu ermitteln oder die Fehlerkorrekturdaten unter Verwendung eines Blockcode-Algorithmus zu ermitteln.

3. Sender (100) gemäß Anspruch 1 oder 2, bei dem die Einrichtung zum Senden (104) ausgebildet ist, um die Datensätze zu einem Datenstrom zusammenzufassen und um die Fehlerkorrekturdaten in den Datenstrom einzufügen.

4. Sender (100) gemäß einem der Ansprüche 1 bis 3, bei dem die Informationsdaten in einem ersten Datensatz und in einem zweiten Datensatz vorliegen, wobei die Einrichtung (102) zum Zuweisen ausgebildet ist, um dem ersten Datensatz eine Versatzinformation zuzuweisen und dem zweiten Datensatz keine Versatzinformation zuzuweisen, und wobei die Einrichtung (104) zum Senden ausgebildet ist, um den ersten Datensatz und den zweiten Datensatz zu senden, und die Einrichtung zum Ermitteln ausgebildet ist, den zweiten Datensatz nicht in die Mehrzahl von Pufferblöcken einzutragen.

5. Sender (100) gemäß einem der Ansprüche 1 bis 4, bei dem in einem ersten Datensatz Informationsdaten einer ersten Aktualität und in einem zweiten Datensatz Informationsdaten einer von der ersten Aktualität verschiedenen zweiten Aktualität vorliegen, wobei die Einrichtung (102) zum Zuweisen ausgebildet ist, dem ersten Datensatz eine erste Aktualitätsinformation zuzuweisen und dem zweiten Datensatz eine zweite Aktualitätsinformation zuzuweisen, und wobei die Einrichtung (104) zum Senden ausgebildet ist, die erste und die zweite Aktualitätsinformation zu senden.

6. Sender (100) gemäß einem der Ansprüche 1 bis 5, bei dem die Einrichtung (104) zum Senden ausgebildet ist, einen ersten Datensatz mit einer ersten Anzahl von Informationsdaten und einen zweiten Datensatz mit einer von der ersten Anzahl von Informationsdaten verschiedenen zweiten Anzahl von Informationsdaten zu senden.

7. Sender (100) gemäß einem der Ansprüche 1 bis 6, bei dem die Einrichtung (104) zum Senden ferner ausgebildet ist, um eine Information über eine Speicherspaltenanzahl oder eine Speicherzeilenanzahl der Speichereinrichtung zu senden.

8. Verfahren zum Senden von Informationsdaten, die in einer Mehrzahl von Datensätzen vorliegen, mit folgenden Schritten:

Ermitteln von Fehlerkorrekturdaten zur Korrektur eines Übertragungsfehlers in einem der Mehrzahl der Datensätze, wobei die Einrichtung zum Ermitteln ausgebildet ist, die Informationsdaten umzusortieren, indem die Informationsdaten von aufeinanderfolgenden Datensätzen reihum zeilenweise in eine Mehrzahl von Pufferblöcken geschrieben werden, wobei eine oder mehrere aufeinanderfolgende Datensätze so lange zeilenweise in denselben Pufferblock geschrieben werden, dass eine Gesamtlänge einer Pufferblockzeile nicht überschritten wird,
wobei die Informationsdaten eines Datensatzes in nicht mehr als einen Pufferblock geschrieben werden, wobei Datensätze, die länger als eine Pufferblockzeile sind, nicht in die Pufferblöcke eingetragen werden und damit die erreichte Interleaving-Distanz den Wert von Pufferblockzeilenlänge mal Pufferblockanzahl hat,
wobei aus den Informationsdaten der einzelnen Pufferblöcke getrennt die Fehlerkorrekturdaten spaltenweise ermittelt werden;
Zuweisen einer Versatzinformation zu einem oder mehreren Datensätzen der Mehrzahl von Datensätzen, wobei die Versatzinformation angibt, in welchem Pufferblock und an welcher Adresse innerhalb dieses Pufferblockes ein entsprechender Datensatz eingeschrieben wurde ;
Senden der Mehrzahl von Datensätzen und der den entsprechenden Datensätzen zugeordneten Versatzinformation, wobei die Informationsdaten nicht-umsortiert übertragen und die Datensätze in Datenpakete einer Transportschicht eingebettet werden, wobei die einem Datensatz zugeordnete Versatzinformation in einem Padding-Bereich der Datenpakete der Transportschicht integrieren wird; und
Aussenden der Fehlerkorrekturdaten.

**EP 1 790 101 B1**

9. Computerprogramm mit Programmcode zur Durchführung des Verfahrens gemäß Anspruch 8, wenn das Computerprogramm auf einem Computer abläuft.

10. Empfänger (150) mit einer Mehrzahl von Pufferblöcken zum Empfangen von Informationsdaten, die in einer Mehrzahl von Datensätzen vorliegen und zum Empfangen einer einem Datensatz zugeordneten Versatzinformation, wobei die dem Datensatz zugeordnete Versatzinformation angibt, in welchem Pufferblock und an welcher Adresse innerhalb dieses Pufferblockes ein entsprechender Datensatz eingeschrieben werden soll, mit folgenden Merkmalen:

   einer Einrichtung (152) zum Empfang der Versatzinformation;
   einer Einrichtung (156) zum Einfügen eines Datensatzes in die Mehrzahl von Pufferblöcken an der durch die Versatzinformation, die dem Datensatz zugewiesen ist, bestimmten Stelle,
   eine Einrichtung zum Empfangen von Fehlerkorrekturdaten; und
   eine Einrichtung zum Korrigieren eines Übertragungsfehlers in einem der Mehrzahl von Datensätzen, die ausgebildet ist, um die Informationsdaten umzusortieren, indem die Informationsdaten von aufeinanderfolgenden Datensätzen reihum zeilenweise gemäß der Versatzinformation in die Mehrzahl von Pufferblöcken geschrieben werden, wobei die Informationsdaten eines Datensatzes in nicht mehr als einen Pufferblock geschrieben werden, wobei eine oder mehrere aufeinanderfolgende Datensätze so lange zeilenweise in denselben Pufferblock geschrieben werden, dass eine Gesamtlänge einer Pufferblockzeile nicht überschritten wird, wobei Datensätze, die länger als eine Pufferblockzeile sind, nicht in die Pufferblöcke eingetragen werden und damit die erreichte Interleaving-Distanz den Wert von Pufferblockzeilenlänge mal Pufferblockanzahl hat, und wobei die Einrichtung zum Korrigieren ausgebildet ist, um unter Verwendung der Fehlerkorrekturdaten die Übertragungsfehler in den Informationsdaten der einzelnen Pufferblöcke getrennt spaltenweise zu korrigieren, wobei die Datensätze und die einem Datensatz zugeordnete Versatzinformation in einem oder mehreren Datenpaketen einer Transportschicht eingebettet sind, wobei die Einrichtung (152) zum Empfangen der Versatzinformation ausgebildet ist, um die Versatzinformation, die einem Datensatz zugeordnet ist, aus einem Padding-Bereich der Datenpakete der Transportschicht zu extrahieren.

11. Empfänger (150) gemäß Anspruch 10, bei dem die Einrichtung zum Korrigieren ausgebildet ist, um den Übertragungsfehler auf der Basis einer EXKLUSIV-ODER-Verknüpfung oder unter Verwendung eines Blockcode-Algorithmus zu korrigieren.

12. Empfänger (150) gemäß Anspruch 10 oder 11, bei dem die Einrichtung (156) zum Einfügen ausgebildet ist, um aus einem Datenstrom, der Datensätze und Fehlerkorrekturdaten umfasst, die Fehlerkorrekturdaten zu extrahieren.

13. Empfänger (150) gemäß einem der Ansprüche 10 bis 12, bei dem die Informationsdaten in einem ersten Datensatz und in einem zweiten Datensatz vorliegen, wobei dem ersten Datensatz eine Versatzinformation zugeordnet ist und dem zweiten Datensatz keine Versatzinformation zugeordnet ist, wobei die Einrichtung zum Einfügen (156) ausgebildet ist, um den ersten Datensatz an der durch die dem ersten Datensatz zugeordnete Versatzinformation bestimmten Stelle in die Mehrzahl von Pufferblöcken einzufügen und den zweiten Datensatz nicht in die Mehrzahl von Pufferblöcken einzufügen.

14. Empfänger (150) gemäß einem der Ansprüche 10 bis 13, bei dem in einem ersten Datensatz Informationsdaten mit einer ersten Aktualitätsinformation und in einem zweiten Datensatz Informationsdaten mit einer von der ersten Aktualitätsinformation verschiedenen zweiten Aktualitätsinformation vorliegen, wobei die zweite Aktualitätsinformation auf eine höhere Aktualität der Informationsdaten des zweiten Datensatzes gegenüber den durch die erste Aktualitätsinformation bezeichneten Aktualität der Informationsdaten des ersten Datensatzes hinweist, und wobei die Einrichtung zum Korrigieren ausgebildet ist, um einen Übertragungsfehler im ersten Datensatz nicht zu korrigieren und einen Übertragungsfehler im zweiten Datensatz zu korrigieren.

15. Empfänger (150) gemäß einem der Ansprüche 10 bis 14, der ausgebildet ist, um einen ersten Datensatz mit einer ersten Anzahl von Informationsdaten und einen zweiten Datensatz mit einer von der ersten Anzahl von Informationsdaten verschiedenen zweiten Anzahl von Informationsdaten zu empfangen.

16. Empfänger (150) gemäß einem der Ansprüche 10 bis 15, bei dem ferner die Einrichtung zum Korrigieren ausgebildet ist, um eine Information über eine Speicherspaltenanzahl oder eine Information über eine Speicherzeilenanzahl der Mehrzahl von Pufferblöcken zu empfangen und in den Speicher in Anhängigkeit von der empfangenen Speicherzeilenanzahl oder der empfangenen Speicherspaltenanzahl zu verändern.

17. Verfahren zum, mit einer Mehrzahl von Pufferblöcken, Empfangen von Informationsdaten, die in einer Mehrzahl von Datensätzen vorliegen und zum Empfangen einer einem Datensatz zugeordneten Versatzinformation, wobei die dem Datensatz zugeordnete Versatzinformation angibt, in welchem Pufferblock und an welcher Adresse innerhalb dieses Pufferblockes ein entsprechender Datensatz eingeschrieben werden soll, mit folgenden Schritten:

Empfangen der Versatzinformation;
Einfügen eines Datensatzes in die Mehrzahl von Pufferblöcken an der durch die Versatzinformation, die dem Datensatz zugewiesen ist, bestimmten Stelle,
Empfangen von Fehlerkorrekturdaten; und
Korrigieren eines Übertragungsfehlers in einem der Mehrzahl von Datensätzen, die ausgebildet ist, um die Informationsdaten umzusortieren, indem die Informationsdaten von aufeinanderfolgenden Datensätzen reihum zeilenweise gemäß der Versatzinformation in die Mehrzahl von Pufferblöcken geschrieben werden, wobei die Informationsdaten eines Datensatzes in nicht mehr als einen Pufferblock geschrieben werden, wobei eine oder mehrere aufeinanderfolgende Datensätze so lange zeilenweise in denselben Pufferblock geschrieben werden, dass eine Gesamtlänge einer Pufferblockzeile nicht überschritten wird, wobei Datensätze, die länger als eine Pufferblockzeile sind, nicht in die Pufferblöcke eingetragen werden und damit die erreichte Interleaving-Distanz den Wert von Pufferblockzeilenlänge mal Pufferblockanzahl hat, und wobei unter Verwendung der Fehlerkorrekturdaten die Übertragungsfehler in den Informationsdaten der einzelnen Pufferblöcke getrennt spaltenweise korrigiert werden,
wobei die Datensätze und die einem Datensatz zugeordnete Versatzinformation in einem oder mehreren Datenpaketen einer Transportschicht eingebettet sind, wobei die Versatzinformation, die einem Datensatz zugeordnet ist, aus einem Padding-Bereich der Datenpakete der Transportschicht extrahiert wird.

18. Computerprogramm mit Programmcode zur Durchführung des Verfahrens gemäß Anspruch 17, wenn das Computerprogramm auf einem Computer abläuft.

## Claims

1. Transmitter (100) for transmitting information data present in a plurality of data sets of different sizes, comprising:

a means for determining error correction data for the correction of a transmission error in one of the plurality of data sets, wherein the means for determining is formed to re-sort the information data by writing the information data of successive data sets in turn row by row into a plurality of buffer blocks, wherein one or several successive data sets are written into the same buffer block row by row for so long that an overall length of a buffer block row is not exceeded,
wherein the information data of a data set are not written into more than one buffer block, wherein data sets that are longer than one buffer block row are not entered into the buffer blocks and hence the obtained interleaving distance has the value of buffer block row length multiplied by buffer block number;
wherein the means for determining is further implemented to separately determine the error correction data column by column from the information data of the individual buffer blocks;
a means (102) for assigning offset information to one or several data sets of the plurality of data sets, wherein the offset information indicates in what buffer block and at what address within this buffer block a corresponding data set has been written;
a means for transmitting the plurality of data sets and the offset information associated with the corresponding data sets, wherein the means (104) for transmitting is formed to transmit the information data in non-re-sorted manner and to embed the data sets in data packets of a transport layer, wherein the means (104) for transmitting is further formed to integrate the offset information associated with a data set into a padding area of the data packets of the transport layer; and
a means for sending out the error correction data.

2. Transmitter (100) of claim 1, wherein the means for determining is formed to determine the error correction data on the basis of an EXCLUSIVE OR combination or to determine the error correction data using a block code algorithm.

3. Transmitter (100) of claim 1 or 2, wherein the means for transmitting (104) is formed to combine the data sets into a data stream and to insert the error correction data into the data stream.

4. Transmitter (100) of one of claims 1 to 3, wherein the information data is present in a first data set and in a second data set, wherein the means (102) for assigning is formed to assign offset information to the first data set and not to assign offset information to the second data set, and wherein the means (104) for transmitting is formed to transmit the first data set and the second data set, and the means for determining is formed to not enter the second data set into the plurality of buffer blocks.

5. Transmitter (100) of one of claims 1 to 4, wherein information data of a first topicality is present in a first data set and information data of a second topicality different from the first topicality in a second data set, wherein the means (102) for assigning is formed to assign first topicality information to the first data set and second topicality information to the second data set, and wherein the means (104) for transmitting is formed to transmit the first and the second topicality information.

6. Transmitter (100) of one of claims 1 to 5, wherein the means (104) for transmitting is formed to transmit a first data set with a first number of information data and a second data set with a second number of information data different from the first number of information data.

7. Transmitter (100) of one of claims 1 to 6, wherein the means (104) for transmitting is further formed to transmit information on a memory column number or a memory row number of the memory means.

8. Method of transmitting information data present in a plurality of data sets, comprising the steps of:

determining error correction data for the correction of a transmission error in one of the plurality of data sets, wherein the means for determining is formed to re-sort the information data, by writing the information data of successive data sets in turn row by row into a plurality of buffer blocks, wherein one or several successive data sets are written into the same buffer block row by row for so long that an overall length of a buffer block row is not exceeded;
wherein the information data of a data set are not written into more than one buffer block, wherein data sets that are longer than one buffer block row are not entered into the buffer blocks and hence the obtained interleaving distance has the value of buffer block row length multiplied by buffer block number;
wherein the error correction data are determined separately column by column from the information data of the individual buffer blocks;
assigning offset information to one or several data sets of the plurality of data sets, wherein the offset information indicates in what buffer block and at what address within this buffer block a corresponding data set has been written;
transmitting the plurality of data sets and the offset information associated with the corresponding data sets, wherein the information data is transmitted in non-re-sorted manner and the data sets are embedded in data packets of a transport layer, wherein the offset information associated with a data set is integrated into a padding area of the data packets of the transport layer; and
sending out the error correction data.

9. Computer program with program code for performing the method of claim 8, when the computer program is executed on a computer.

10. Receiver (150) having a plurality of buffer blocks for receiving information data present in a plurality of data sets, and for receiving offset information associated with a data set, the offset information associated with the data set indicating in what buffer block and at what address within this buffer block a corresponding data set is to be entered, comprising:

a means (152) for receiving the offset information;
a means (156) for inserting a data set into the plurality of buffer blocks at the location determined by the offset information assigned to the data set;
a means for receiving error correction data;
a means for correcting a transmission error in one of the plurality of data sets, which is formed to re-sort the information data by writing the information data of successive data sets in turn row by row into the plurality of buffer blocks according to the offset information, wherein the information data of a data set are not written into more than one buffer block, wherein one or several successive data sets are written into the same buffer block row by row for so long that an overall length of a buffer block row is not exceeded, wherein data sets that are longer than one buffer block row are not entered into the buffer blocks and hence the obtained interleaving distance has the value of buffer block row length multiplied by buffer block number, and wherein the means for correcting is formed to separately correct the transmission errors in the information data of the individual buffer blocks column by column by using the error correction data,

wherein the data sets and the offset information associated with a data set are embedded in one or several data packets of a transport layer, wherein the means (152) for receiving the offset information is formed to extract the offset information associated with a data set from a padding area of the data packets of the transport layer.

11. Receiver (150) of claim 10, wherein the means for correcting is formed to correct the transmission error on the basis of an EXCLUSIVE OR combination or using a block code algorithm.

12. Receiver (150) of claim 10 or 11, wherein the means (156) for inserting is formed to extract the error correction data from a data stream that includes data sets and error correction data.

13. Receiver (150) of one of claims 10 to 12, wherein the information data is present in a first data set and in a second data set, wherein offset information is associated with the first data set and no offset information is associated with the second data set, wherein the means for inserting (156) is formed to insert the first data set into the plurality of buffer blocks at the location determined by the offset information associated with the first data set and not insert the second data set into the plurality of buffer blocks.

14. Receiver (150) of one of claims 10 to 13, wherein information data with first topicality information is present in a first data set and information data with second topicality information different from the first topicality information is present in a second data set, wherein the second topicality information indicates higher topicality of the information data of the second data set as opposed to the topicality of the information of the first data set designated by the first topicality information, and wherein the means for correcting is formed to not correct a transmission error in the first data set and correct a transmission error in the second data set.

15. Receiver (150) of one of claims 10 to 14, which is formed to receive a first data set with a first number of information data and a second data set with a second number of information data different from the first number of information data.

16. Receiver (150) of one of claims 10 to 15, wherein the means for correcting is further formed to receive information on a memory column number or information on a memory row number of the plurality of buffer blocks and change the memory depending on the received memory row number or the received memory column number.

17. Method of receiving, with a plurality of buffer blocks, information data present in a plurality of data sets and for receiving offset information associated with a data set, the offset information associated with the data set indicating in what buffer block and at what address within this buffer block a corresponding data set is to be written, comprising the steps of:

receiving the offset information;
inserting a data set into the plurality of buffer blocks at the location determined by the offset information associated with the data set;
receiving error correction data;
correcting a transmission error in one of the plurality of data sets, which is formed to re-sort the information data by writing the information data of successive data sets in turn row by row into the plurality of buffer blocks according to the offset information, wherein the information data of a data set are not written into more than one buffer block, wherein one or several successive data sets are written into the same buffer block row by row for so long that an overall length of a buffer block row is not exceeded, wherein data sets that are longer than one buffer block row are not entered into the buffer blocks and hence the obtained interleaving distance has the value of buffer block row length multiplied by buffer block number, and wherein transmission errors in the information data of the individual buffer blocks are corrected separately column by column by using the error correction data,
wherein the data sets and the offset information associated with a data set are embedded in one or several data packets of a transport layer, wherein the offset information associated with a data set is extracted from a padding area of the data packets of the transport layer.

18. Computer program with program code for performing the method of claim 17, when the computer program is executed on a computer.

**Revendications**

1. Emetteur (100) pour émettre des données d'informations qui sont présentes dans une pluralité d'ensembles de données de grandeur différente, aux caractéristiques suivantes:

   un moyen destiné à déterminer des données de correction d'erreur pour la correction d'une erreur de transmission dans l'un de la pluralité d'ensembles de données, le moyen destiné à déterminer étant réalisé pour retrier les données d'informations en ce que les données d'informations d'ensembles de données successifs sont, à tour de rôle, écrites par rangée dans une pluralité de blocs tampons, un ou plusieurs ensembles de données successifs étant écrits par rangée dans le même bloc tampon tant qu'une longueur totale d'une rangée de bloc tampon n'est pas excédée,
   dans lequel les données d'informations d'un ensemble de données sont écrites dans pas plus d'un bloc tampon, les ensembles de données qui sont plus longs qu'une rangée de bloc tampon n'étant pas entrés dans les blocs tampons et la distance d'entrelacement obtenue présentant de ce fait la valeur de longueur de rangée de bloc tampon fois le nombre de blocs tampons,
   dans lequel le moyen destiné à déterminer est par ailleurs réalisé pour déterminer séparément, à partir des données d'informations des blocs tampons individuels, les données de correction d'erreur par colonne;
   un moyen (102) destiné à attribuer une information de décalage à un ou plusieurs ensembles de données de la pluralité d'ensembles de données, l'information de décalage indiquant le bloc tampon dans lequel et l'adresse dans ce bloc tampon à laquelle a été écrit un ensemble de données correspondant;
   un moyen destiné à émettre la pluralité d'ensembles de données et l'information de décalage associée aux ensembles de données correspondants, le moyen (104) destiné à émettre étant réalisé pour transmettre les données d'informations non retriées et pour incorporer les ensembles de données dans des paquets de données dans une couche de transport, le moyen (104) destiné à émettre étant par ailleurs réalisé pour incorporer l'information de décalage associée à un ensemble de données dans une zone de remplissage des paquets de données de la couche de transport; et
   un moyen destiné à émettre les données de correction d'erreur.

2. Emetteur (100) selon la revendication 1, dans lequel le moyen destiné à déterminer est réalisé pour déterminer les données de correction d'erreur sur base d'un couplage OU EXCLUSIF ou pour déterminer les données de correction d'erreur à l'aide d'un algorithme de code de bloc.

3. Emetteur (100) selon la revendication 1 ou 2, dans lequel le moyen destiné à émettre (104) est réalisé pour regrouper les ensembles de données en un flux de données et pour insérer les données de correction d'erreur dans le flux de données.

4. Emetteur (100) selon l'une des revendications 1 à 3, dans lequel les données d'informations sont présentes dans un premier ensemble de données et dans un deuxième ensemble de données, le moyen (102) destiné à attribuer étant réalisé pour attribuer une information de décalage au premier ensemble de données et ne pas attribuer d'information de décalage au deuxième ensemble de données, et le moyen (104) destiné à émettre étant réalisé pour émettre le premier ensemble de données et le deuxième ensemble de données, et le moyen destiné à déterminer étant réalisé pour ne pas entrer le deuxième ensemble de données dans la pluralité de blocs tampons.

5. Emetteur (100) selon l'une des revendications 1 à 4, dans lequel sont présentes, dans un premier ensemble de données, des données d'information d'une première actualité et, dans un deuxième ensemble de données, des données d'information d'une deuxième actualité différente de la première actualité, le moyen (102) destiné à attribuer étant réalisé pour attribuer, au premier ensemble de données, une première information d'actualité et, au deuxième ensemble de données, une deuxième information d'actualité, et le moyen (104) destiné à émettre étant réalisé pour émettre la première et la deuxième information d'actualité.

6. Emetteur (100) selon l'une des revendications 1 à 5, dans lequel le moyen (104) destiné à émettre est réalisé pour émettre un premier ensemble de données avec un premier nombre de données d'informations et un deuxième ensemble de données avec un deuxième nombre de données d'informations différent du premier nombre de données d'informations.

7. Emetteur (100) selon l'une des revendications 1 à 6, dans lequel le moyen (104) destiné à émettre est par ailleurs réalisé pour émettre une information sur un nombre de colonnes de mémoire ou un numéro de rangées de mémoire du dispositif de mémoire.

8. Procédé pour émettre des données d'information qui sont présentes dans une pluralité d'ensembles de données, aux étapes suivantes consistant à:

déterminer des données de correction d'erreur pour corriger une erreur de transmission dans l'un de la pluralité d'ensembles de données, le moyen destiné à déterminer étant réalisé pour retrier les données d'informations en ce que les données d'informations d'ensembles de données successifs sont, à tour de rôle, écrites par rangée dans une pluralité de blocs tampons, un ou plusieurs ensembles de données successifs étant écrits par rangée dans le même bloc tampon tant qu'une longueur totale d'une rangée de bloc tampon n'est pas excédée,

dans lequel les données d'informations d'un ensemble de données sont écrites dans pas plus d'un bloc tampon, les ensembles de données qui sont plus longs qu'une rangée de bloc tampon n'étant pas entrés dans les blocs tampons et la distance d'entrelacement obtenue présentant de ce fait la valeur de longueur de rangée de bloc tampon fois le nombre de blocs tampons,

dans lequel les données de correction d'erreur sont déterminées séparément par colonne à partir des données d'informations des blocs tampons individuels;

attribuer une information de décalage à un ou plusieurs ensembles de données de la pluralité d'ensembles de données, l'information de décalage indiquant le bloc tampon dans lequel et l'adresse dans ce bloc tampon à laquelle a été écrit un ensemble de données correspondant;

émettre la pluralité d'ensembles de données et l'information de décalage associée aux ensembles de données correspondants, les données d'informations étant émises non retriées et les ensembles de données étant incorporés dans des paquets de données d'une couche de transport, une information de décalage associée à un ensemble de données étant intégrée dans une zone de remplissage des paquets de données de la couche de transport; et

émettre les données de correction d'erreur.

9. Programme d'ordinateur avec un code de programme pour réaliser le procédé selon la revendication 8 lorsque le programme d'ordinateur est exécuté sur un ordinateur.

10. Récepteur (150) avec une pluralité de blocs tampons destinés à recevoir des données d'informations qui sont présentes dans une pluralité d'ensembles de données et à recevoir une information de décalage associée à un ensemble de données, l'information de décalage associée à l'ensemble de données indiquant le bloc tampon dans lequel et l'adresse dans ce bloc tampon à laquelle doit être écrit un ensemble de données correspondant, aux caractéristiques suivantes:

un moyen (152) destiné à recevoir l'information de décalage;

un moyen (156) destiné à introduire un ensemble de données dans la pluralité de blocs tampons à l'endroit déterminé par l'information de décalage qui est attribuée à l'ensemble de données,

un moyen destiné à recevoir des données de correction d'erreur; et

un moyen destiné à corriger une erreur de transmission dans l'un de la pluralité d'ensembles de données qui est réalisé pour retrier les données d'informations en ce que les données d'informations d'ensembles de données successifs sont, à tour de rôle, écrites par rangée selon les informations de décalage dans la pluralité de blocs tampons, les données d'information d'un ensemble de données étant écrites dans pas plus d'un bloc tampon, un ou plusieurs ensembles de données successifs étant écrits par rangée dans le même bloc tampon tant qu'une longueur totale d'une rangée de bloc tampon n'est pas excédée, les ensembles de données qui sont plus longs qu'un rangée de bloc tampon n'étant pas entrés dans les blocs tampons et la distance d'entrelacement atteinte présentant de ce fait la valeur de la longueur de rangée de bloc tampon fois le nombre de blocs tampons, et le moyen destiné à corriger étant réalisé pour corriger, à l'aide des données de correction d'erreur, séparément par colonne, les erreurs de transmission dans les données d'informations des blocs tampons individuels,

dans lequel les ensembles de données et l'information de décalage associée à un ensemble de données sont incorporés dans un ou plusieurs paquets de données d'une couche de transport, le moyen (152) destiné à recevoir étant réalisé pour extraire l'information de décalage qui est associée à un ensemble de données d'une zone de remplissage des paquets de données de la couche de transport.

11. Récepteur (150) selon la revendication 10, dans lequel le moyen destiné à corriger est réalisé pour corriger l'erreur de transmission sur base d'un couplage OU EXCLUSIF ou à l'aide d'un algorithme de code de bloc.

12. Récepteur (150) selon la revendication 10 ou 11, dans lequel le moyen (156) destiné à introduire est réalisé pour extraire les données de correction d'erreur d'un flux de données comportant des ensembles de données et des données de correction d'erreur.

**13.** Récepteur (150) selon l'une des revendications 10 à 12, dans lequel les données d'information sont présentes dans un premier ensemble de données et dans un deuxième ensemble de données, au premier ensemble de données étant associée une information de décalage et au deuxième ensemble de données n'étant pas associée d'information de décalage, le moyen destiné à introduire (156) étant réalisé pour introduire le premier ensemble de données à l'endroit déterminé par l'information de décalage associée au premier ensemble de données dans la pluralité de blocs tampons et pour ne pas introduire le deuxième ensemble de données dans la pluralité de blocs tampon.

**14.** Récepteur (150) selon l'une des revendications 10 à 13, dans laquelle sont présentes, dans un premier ensemble de données, des données d'information avec une première information d'actualité et, dans un deuxième ensemble de données, des données d'information avec une deuxième information d'actualité différente de la première information actualité, la deuxième information d'actualité indiquant une actualité supérieure des données d'information du deuxième ensemble de données par rapport à l'actualité désignée par la première information d'actualité du premier ensemble de données, et le moyen destiné à corriger étant réalisé pour ne pas corriger une erreur de transmission dans le premier ensemble de données et pour corriger une erreur de transmission dans le deuxième ensemble de données.

**15.** Récepteur (150) selon l'une des revendications 10 à 14, qui est réalisé pour recevoir un premier ensemble de données avec un premier nombre de données d'informations et un deuxième ensemble de données avec un deuxième nombre de données d'informations différent du premier nombre de données d'informations.

**16.** Récepteur (150) selon l'une des revendications 10 à 15, dans lequel par ailleurs le moyen destiné à corriger est réalisé pour recevoir une information sur un nombre de colonnes de mémoire ou une information sur un nombre de rangées de mémoire de la pluralité de blocs tampons et pour les modifier dans la mémoire en fonction du nombre de rangées de mémoire reçu ou du nombre de colonnes de mémoire reçu.

**17.** Procédé pour recevoir, par une pluralité de blocs tampons, des données d'information qui sont présentes dans une pluralité d'ensembles de données et pour recevoir une information de décalage associée à un ensemble de données, l'information de décalage associée à l'ensemble de données indiquant le bloc tampon dans lequel et l'adresse dans ce bloc tampon à laquelle doit être écrit un ensemble de données correspondant, aux étapes suivantes consistant à:

recevoir l'information de décalage;
introduire un ensemble de données dans la pluralité de blocs tampons à l'endroit déterminé par l'information de décalage qui est attribuée à l'ensemble de données,
recevoir des données de correction d'erreur; et
corriger une erreur de transmission dans l'un de la pluralité d'ensembles de données, qui est réalisé pour retrier les données d'informations en ce que les données d'informations d'ensembles de données successifs sont écrites, à tour de rôle, par rangée selon l'information de décalage dans la pluralité de blocs tampons, les données d'informations d'un ensemble de données étant écrites dans pas plus d'un bloc tampon, un ou plusieurs ensembles de données successifs étant écrits dans le même bloc tampon tant qu'une longueur totale d'une rangée de bloc tampon n'est pas excédée, les ensembles de données qui sont plus longues qu'une rangée de bloc tampon n'étant pas entrés dans les blocs tampons et la distance d'entrelacement atteinte présentant de ce fait la valeur de longueur de rangée de bloc tampon fois le nombre de blocs tampons, et les erreurs de transmission dans les données d'informations des blocs tampons individuels étant corrigées séparément par colonne à l'aide des données de correction d'erreur,
dans lequel les ensembles de données et l'information de décalage associée à un ensemble de données sont incorporés dans un ou plusieurs paquets de données d'une couche de transport, l'information de décalage qui est associée à un ensemble de données étant extraite d'une zone de remplissage des paquets de données de la couche de transport.

**18.** Programme d'ordinateur avec un code de programme pour réaliser le procédé selon la revendication 17 lorsque le programme d'ordinateur est exécuté sur un ordinateur.

EP 1 790 101 B1

100

102

INFORMATIONSDATEN
IN DATENSÄTZEN

EINRICHTUNG ZUM
ZUWEISEN

DATENSATZ
UND VERSATZ-
INFORMATION

EINRICHTUNG ZUM
SENDEN

DATENSÄTZE UND
EINEM DATENSATZ
ZUGEWIESENE
VERSATZINFORMATION

104

FIG. 1A

DATENSÄTZE UND
EINEM DATENSATZ
ZUGEWIESENE
VERSATZINFORMATION

150

152

EINRICHTUNG ZUM
EMPFANGEN

VERSATZINFORMATION

EINRICHTUNG ZUM
EINFÜGEN

156

SPEICHER-
EINRICHTUNG

154

FIG. 1B

FIG. 2A

FIG. 2B

EP 1 790 101 B1

DATENGRUPPE 1    DATENGRUPPE 2              ...

| 1 | 2 | 3 | 4 | 5 | ... |

EINTRAGEN DER DATEN-
GRUPPEN IN DEN
INTERLEAVER-BUFFER

AUSLESERICHTUNG
FÜR CODEWORT-
BILDUNG

FIG. 3

EINTRAGRICHTUNG

FIG. 4

FIG. 5

CODEWORT (ACHT SYMBOLE)

| A | B | C | D | E | F | G | H |

X   REDUNDANZ-
    SYMBOL

XOR → XOR → XOR → XOR → XOR → XOR → XOR

FIG. 6

EP 1 790 101 B1

| MSC DATEN-GRUPPEN HEADER | MSC DATENGRUPPEN DATENFELD | MSC DATEN-GRUPPEN CRC |
|---|---|---|

| 72 bits | 2*8*n bits | |
|---|---|---|
| FEC HEADER | DATENGRUPPEN OFFSETS | FEC DATEN |

| BLOCK Idx | BLOCK ID | padding lengths | START OFFSET | END OFFSET | TransID Flag | data group count indicator n | MOT-Dir Transport ID |
|---|---|---|---|---|---|---|---|
| 3 bits | 5 bits | 16 bits | 16 bits | 16 bits | 1 bit | 15 bits | 16 bits |

FIG. 7

EP 1 790 101 B1

PAKET

| HEADER | NUTZBYTES | PADDING | CRC |

PAKET ("LAST PACKET FLAG" GESETZT)

| HEADER | NUTZBYTE 3 BYTE ZUSATZ-INFORMATIONEN | PADDING | CRC |

FIG. 8

EP 1 790 101 B1

MOT
DIRECTORY
SEGMENT

MOT
BODY
SEGMENTE

FALSCH
REKONSTRUIERTES
MOT DIRECTORY
SEGMENT

ZEIT

EMPFANGS-
FEHLER

AUSSENDUNG EINES
GEÄNDERTEN MOT
DIRECTORYS UND NEUER
DATENGRUPPEN

FEC DATEN-
EMPFANG

FIG. 9

EP 1 790 101 B1

NACHRICHTEN-SYMBOLE | 1 | 2 | 3 | 4 | 5 | 6 | 7 | 8 | 9 | 10 | 11 | 12 | ...

BURSTFEHLER

| 1 | 2 | 3 | 4 | 5 | → | □ |
| 6 | 7 | 8 | 9 | 10 | → | □ |
| 11 | 12 | 13 | 14 | 15 | → | □ | GENERIERTE REDUNDANZ-SYMBOLE |
| 16 | 17 | 18 | 19 | 20 | → | □ |
| 21 | 22 | 23 | 24 | 25 | → | □ |

⋮

## FIG. 10A

INTERLEAVINGDISTANZ

NACHRICHTEN-SYMBOLE | 1 | 2 | 3 | 4 | 5 | 6 | 7 | 8 | 9 | 10 | 11 | 12 | ...

BURSTFEHLER

| 1 | 6 | 11 | 16 | 21 | → | □ |
| 2 | 7 | 12 | 17 | 22 | → | □ |
| 3 | 8 | 13 | 18 | 23 | → | □ | GENERIERTE REDUNDANZ-SYMBOLE |
| 4 | 9 | 14 | 19 | 24 | → | □ |
| 5 | 10 | 15 | 20 | 25 | → | □ |

⋮

## FIG. 10B

**IN DER BESCHREIBUNG AUFGEFÜHRTE DOKUMENTE**

**In der Beschreibung aufgeführte Patentdokumente**

- US 20030207696 A1

- EP 1014730 A

**In der Beschreibung aufgeführte Nicht-Patentliteratur**

- **JOHN L. RAMSEY.** Realization of Optimum Interleavers. *IEEE Transactions on Information Theory,* Mai 1970, vol. IT-16 (3